# EUROPÄISCHE PATENTANMELDUNG

(11) **EP 4 471 874 A1**
(43) Veröffentlichungstag der Anmeldung: **04.12.2024**
(21) Anmeldenummer: 23176771.6
(22) Anmeldetag: 01.06.2023
(51) Int. Cl.: H01L 31/02, H02S 30/10, H02S 40/34

(54) **VERFAHREN ZUR HERSTELLUNG EINES GERAHMTEN SOLARMODULS ODER EINES GERAHMTEN SOLARARRAYS, RAHMENMODUL SOWIE GERAHMTES SOLARMODUL ODER GERAHMTES SOLARARRAY**

(71) Anmelder: Meyer Burger Industries GmbH, 09599 Freiberg (DE)
(72) Erfinder: Böddicker, Alexander, Freiberg (DE)
(74) Vertreter: Kailuweit & Uhlemann Patentanwälte Partnerschaft mbB

(57) **Zusammenfassung**

Die Erfindung betrifft ein Verfahren zur Herstellung eines gerahmten Solarmoduls aus Solarzellen oder eines gerahmten Solararrays aus Solarmodulen. Das Verfahren umfasst das Bereitstellen eines Schichtstapels, das Bereitstellen eines Rahmenmoduls sowie das Erzeugen des gerahmten Solarmoduls oder Solararrays aus dem Schichtstapel und dem Rahmenmodul, wobei der Schichtstapel und das Rahmenmodul zusammengefügt werden und ein Rahmen erzeugt wird. Dabei durchdringen elektrisch leitfähige Kontaktierungskontakte des Rahmenmoduls den Schichtstapel zumindest bis zu elektrisch leitfähigen Kontaktflächen von mindestens zwei Strings aus Solarzellen oder Solarmodulen und kontaktieren diese elektrisch. Dadurch wird ein elektrischer Kontakt zwischen den mindestens zwei Strings und einer im Rahmenmodul enthaltenen elektrischen Schaltung gebildet. Die Erfindung betrifft weiterhin ein Rahmenmodul zur Herstellung eines gerahmten Solarmoduls oder eines gerahmten Solararrays.

## Beschreibung

Die Erfindung betrifft ein Verfahren zur Herstellung eines gerahmten Solarmoduls oder eines gerahmten Solararrays, ein Rahmenmodul sowie ein gerahmtes Solarmodul oder ein gerahmtes Solararray.

Mit zunehmender Knappheit an fossilen Brennstoffen steigt die Nachfrage nach Technologien für die Nutzung erneuerbarer Energien, wie beispielsweise Photovoltaikanlagen, die auch als photovoltaische Solaranlagen oder kurz Solaranlagen bezeichnet werden. Solarmodule umfassen typischerweise eine Vielzahl an Solarzellen, während Solaranlagen eine Vielzahl von Solarmodulen aufweisen, die in einem Solararray angeordnet sein können. Die Herstellung von Solarmodulen und -anlagen ist zeit- und arbeitsaufwendig. Insbesondere die Verkapselung und elektrische Kontaktierung müssen sorgfältig ausgeführt werden, um eine hohe Witterungsbeständigkeit und Durchschlagfestigkeit zu erzielen, und somit eine lange Lebensdauer der Solarmodule bzw. Solaranlagen zu gewährleisten.

In einem Solarmodul sind typischerweise mehrere Solarzellen elektrisch in Reihe oder parallel zueinander zu sogenannten Solarzellen-Strings geschalteten. Diese Solarzellen-Strings können am Anfang und Ende des jeweiligen Solarzellen-Strings mit Stromsammlern, auch Querverbinder oder Interkonnektoren genannt, ausgebildet sein, über die mehrere der Solarzellen-Strings elektrisch miteinander zu einem Solarmodul verbunden bzw. verschaltet werden können. Analog zu Solarzellen können auch Solarmodule elektrisch parallel oder in Reihe zueinander zu sogenannten Modul-Strings verbunden sein und mehrere solcher Modul-Strings über endseitige Stromsammler elektrisch miteinander zu Solararrays verbunden bzw. verschaltet werden.

Für die externe elektrische Kontaktierung von Solarmodulen oder Solararrays ist eine Anschlussdose vorgesehen. Diese Anschlussdose befindet sich üblicherweise auf der Rückseite des Solarmoduls bzw. des -arrays, um Verschattung zu vermeiden. Bei der Herstellung des Solarmoduls oder -arrays werden die miteinander verschalteten Strings über Kontaktierungsleiter elektrisch mit der Anschlussdose verbunden. Das Anschließen der Anschlussdose ist jedoch sehr aufwändig und meist nur manuell möglich.

Vor der Verkapselung und bzw. oder Verglasung des Solarmoduls oder -arrays müssen die Kontaktierungsleiter zu einer rückseitigen Anschlussposition für die Anschlussdose geführt werden. Nach der Verkapselung und bzw. oder Verglasung muss diese Anschlussposition an der Rückseite des Solarmoduls bzw. -arrays aufgefunden werden und das Solarmodul bzw. -array an der Anschlussposition geöffnet werden. Dann müssen die Kontaktierungsleiter durch die geschaffene Öffnung geführt werden und mit den Kontakten der Anschlussdose elektrisch verbunden werden.

Aus der DE 10 2009 034 656 A1 ist eine Montagehilfe bekannt, die das Durchführen der Kontaktierungsleiter durch die Verkapselungsschicht und die Rückseitenschicht erleichtert, allerdings sind dafür mehrere Arbeitsschritte, insbesondere Positioniervorgänge, erforderlich. Die Verkapselungsschicht und die Rückseitenschicht des Solarmoduls oder -arrays müssen an der Anschlussposition mit Öffnungen vorgefertigt werden. Die Montagehilfe muss vor der Verkapselung bzw. Verglasung korrekt auf den Kontaktierungsleitern positioniert werden. Anschließend müssen die Verkapselungsschicht und die Rückseitenschicht mit ihren Öffnungen über der Montagehilfe positioniert werden, die Kontaktierungsleiter mithilfe der Montagehilfe durch die Öffnungen geführt werden und der Laminiervorgang durchgeführt werden. Für den Einsatz der Montagehilfe müssen die Öffnungen einen größeren Querschnitt als die Kontaktierungsleiter aufweisen. Deshalb müssen die Öffnungen nach dem Durchführen der Kontaktierungsleiter in einem gesonderten Arbeitsschritt auch noch abgedichtet werden, um eine Fixierung bzw. Zugentlastung der Kontaktierungsleiter und einen Witterungsschutz zu gewährleisten. Mit der Montagehilfe kann das Anschließen der Anschlussdose demnach zwar automatisiert werden, ist jedoch weiterhin sehr zeitaufwändig und fehleranfällig.

Aufgabe der Erfindung ist es daher, die Nachteile im Stand der Technik zu überwinden und ein Verfahren anzugeben, mit dem gerahmte Solarmodule oder -arrays, insbesondere hinsichtlich der elektrischen Kontaktierung, Rahmung oder Abdichtung, effizient hergestellt werden können. Die Erfindung betrifft weiterhin ein Rahmenmodul für die Herstellung eines gerahmten Solarmoduls oder eines gerahmten Solararrays sowie ein gerahmtes Solarmodul bzw. ein gerahmtes Solararray.

Erfindungsgemäß wird die Aufgabe durch eine Verfahren nach Anspruch 1 und ein Rahmenmodul nach Anspruch 14 gelöst. Vorteilhafte Ausgestaltungen der Erfindung sind in den abhängigen Ansprüchen angegeben.

Das Verfahren kann zur Herstellung von Solarmodulen aus Solarzellen oder Solararrays aus Solarmodulen verwendet werden. Solarzellen können z. B. Silizium-basierte Solarzellen, Gallium-Arsenid-Solarzellen, Cadmium-Tellurid-Solarzellen, CIS- oder CIGS-Solarzellen oder auch organische Solarzellen sein. Wird das Verfahren zur Herstellung von Solararrays angewendet, um aus mehreren Solarmodulen ein Solararray und daraus eine Solaranlage herzustellen, so können die Solarmodule beispielsweise aus den genannten Solarzellen aufgebaut sein.

Bei dem Verfahren zur Herstellung eines gerahmten Solarmoduls aus Solarzellen oder eines gerahmten Solararrays aus Solarmodulen wird ein laminierter Schichtstapel bereitgestellt, der eine Vorderseitenschicht, eine erste Verkapselungsschicht, mindestens zwei Strings aus Solarzellen oder mindestens zwei Strings aus Solarmodulen, eine zweite Verkapselungsschicht und eine Rückseitenschicht umfasst. Die Solarzellen oder Solarmodule sind in den mindestens zwei Strings jeweils mit einer elektrisch leitfähigen Leiterstruktur, im Folgenden Leiterstruktur genannt, elektrisch in Reihe oder elektrisch parallel zueinander verbunden und an jedem der mindestens zwei Strings ist jeweils endseitig an der Leiterstruktur eine elektrisch leitfähige Kontaktfläche, im Folgenden Kontaktflächen genannt, ausgebildet. Der laminierte Schichtstapel ist außerdem derart laminiert, dass die mindestens zwei Strings und die Leiterstrukturen, in dem Bereich, in dem sie die Solarzellen oder Solarmodule elektrisch miteinander verbinden, von der ersten Verkapselungsschicht und der zweiten Verkapselungsschicht umgeben, d.h. verkapselt, sind. Die Leiterstrukturen an den Enden der mindestens zwei Strings und die Kontaktflächen können von der ersten Verkapselungsschicht und der zweiten Verkapselungsschicht umgeben sein oder zumindest teilweise außerhalb der ersten und zweiten Verkapselungsschicht angeordnet sein, beispielsweise an Außenkanten, d.h. an Randbereichen, der ersten Verkapselungsschicht und der zweiten Verkapselungsschicht, insbesondere in berührendem Kontakt mit der ersten und der zweiten Verkapselungsschicht.

Des Weiteren wird ein Rahmenmodul bereitgestellt, das einen Schaltungsträger mit einer elektrischen Schaltung und elektrisch leitfähigen Kontaktierungskontakten, im Folgenden Kontaktierungskontakte genannt, enthält. Anschließend wird unter Zusammenfügen des Schichtstapels und des Rahmenmoduls das gerahmte Solarmodul oder das gerahmte Solararray erzeugt, wobei das gerahmte Solarmodul oder das gerahmte Solararray einen Rahmen enthält. Mit anderen Worten: Es wird der Rahmen erzeugt, der mit dem Schichtstapel verbunden ist und in dem der Schaltungsträger integriert ist.

Das Rahmenmodul kann bereits ein Rahmenvorformling sein, der beispielsweise aus mehreren Teilen bestehen kann. Der Rahmenvorformling ist dabei ein Bauteil, das durch nachfolgende Schritte des Verfahrens in den Rahmen des gerahmten Solarmoduls oder des gerahmten Solararrays umgeformt wird oder dessen Teile zu dem Rahmen zusammengefügt werden. Der Rahmenvorformling selbst kann als der Schaltungsträger ausgebildet sein, auf oder in dem die elektrische Schaltung und auf dessen Oberfläche die Kontaktierungskontakte ausgebildet sind. Alternativ oder zusätzlich kann der Rahmenvorformling auch ein Zwischensubstrat als den Schaltungsträger enthalten, auf oder in dem die elektrische Schaltung und auf dessen Oberfläche die Kontaktierungskontakte ausgebildet sind. Solch ein Zwischensubstrat kann auch aus mehreren Teilstücken bestehen und kann bspw. eine Leiterplatte, eine Folie oder jedes andere geeignete Substrat sein, das die Funktionsfähigkeit der elektrischen Schaltung ermöglicht. Ein Rahmenvorformling kann bspw. aus einer ersten Rahmenschale und einer zweiten Rahmenschale bestehen, wobei die elektrische Schaltung und die Kontaktierungskontakte direkt in das Material des Rahmenvorformlings, bspw. in eine der beiden Rahmenschalen oder in beide Rahmenschalen, integriert sind oder wobei das Zwischensubstrat in eine der beiden oder in beide Rahmenschalen integriert ist.

In anderen Ausführungsformen besteht das Rahmenmodul nur aus dem Schaltungsträger, welcher ein separates Substrat ist, das ebenfalls aus mehreren Teilstücken bestehen kann. Das separate Substrat ist zwar später Bestandteil des erzeugten Rahmens, jedoch kann der Rahmen nicht aus dem separaten Substratträger selbst heraus erzeugen werden. Solch ein Substrat kann bspw. eine Leiterplatte, eine Folie oder jedes andere geeignete Substrat sein, dass die Funktionsfähigkeit der elektrischen Schaltung ermöglicht.

Erfindungsgemäß sind die Kontaktierungskontakte derart ausgebildet, dass sie beim Erzeugen des Rahmens den laminierten Schichtstapel, zumindest bis zu den Kontaktflächen, durchdringen und jeweils mindestens eine Kontaktfläche elektrisch kontaktieren. Dadurch wird beim Erzeugen des Rahmens ein elektrischer Kontakt zwischen den mindestens zwei Strings und der elektrischen Schaltung des Schaltungsträgers gebildet. Somit ist eine Verwendung von Montagehilfen zum Durchführen von Kontaktierungsleitern nicht mehr notwendig und das zeitaufwändige Verlöten von Kontaktierungsleiter entfällt. Das Verfahren ist daher ohne großen Aufwand durchführbar und kann auch einfach automatisiert werden.

Unter Durchdringen des Schichtstapels wird im Sinne der Anmeldung verstanden, dass die Kontaktierungskontakte mindestens eine der folgenden Schichten durchdringen: die Vorderseitenschicht, die erste Verkapselungsschicht, die Kontaktfläche, die zweite Verkapselungsschicht und die Rückseitenschicht. In jedem Fall werden jedoch alle Schichten, die vor dem Erzeugen des Rahmens die jeweilige Kontaktfläche auf einer ihrer Oberflächen bedeckt, durchdrungen. Ist beispielsweise die Kontaktfläche auf einer Oberfläche im Bereich des zu erzeugenden elektrischen Kontaktes zu einem Kontaktierungskontakt nur von der ersten Verkapselungsschicht bedeckt, nicht aber von der Vorderseitenschicht, so wird auf dieser Seite der Kontaktfläche nur die erste Verkapselungsschicht durchdrungen. Ist in einem anderen Bespiel die Kontaktfläche auf einer Oberfläche im Bereich des zu erzeugenden elektrischen Kontaktes zu einem Kontaktierungskontakt von der zweiten Verkapselungsschicht und der Rückseitenschicht bedeckt, so werden auf dieser Seite der Kontaktfläche die Rückseitenschicht und die zweite Verkapselungsschicht durchdrungen. Darüber hinaus können die Kontaktierungskontakte auch in die jeweilige Kontaktfläche eindringen oder diese durchdringen. Wenn die Kontaktierungskontakte die Kontaktfläche durchdringen, so können sie auch in eine Schicht des Schichtstapels, die auf der anderen Oberfläche der Kontaktfläche vorhanden ist, eindringen oder diese durchdringen. Die andere Oberfläche der Kontaktfläche ist hier die Oberfläche, die zu Beginn des Zusammenfügens des Schichtstapels und des Rahmenmoduls nicht dem Kontaktierungskontakt gegenüberlag. Darüber hinaus ist es auch möglich, dass eine Kontaktfläche an ihren beiden Oberflächen von jeweils mindestens einem Kontaktierungskontakt kontaktiert werden, wobei der entsprechende Kontaktierungskontakt dann die auf der entsprechenden Oberfläche der Kontaktfläche vor dem Erzeugen des Rahmens bestehenden Schichten durchdringt.

In Ausführungsformen kann der laminierte Schichtstapel bereitgestellt werden, indem eine Vorderseitenschicht, eine erste Verkapselungsschicht, mindestens zwei Strings aus Solarzellen oder mindestens zwei Strings aus Solarmodulen, eine zweiten Verkapselungsschicht und eine Rückseitenschicht in der genannten oder umgekehrter Reihenfolge bereitgestellt werden und durch Laminieren der ersten Verkapselungsschicht und der zweiten Verkapselungsschicht zu einem laminierten Schichtstapel zusammengefügt werden. Beim Laminieren werden mit der ersten Verkapselungsschicht und der zweiten Verkapselungsschicht die mindestens zwei Strings aus Solarzellen oder Solarmodulen verkapselt, d. h. von den Verkapselungsschichten umschlossen, wobei die Leiterstrukturen und Kontaktflächen an den Enden der mindestens zwei Strings von der ersten Verkapselungsschicht und der zweiten Verkapselungsschicht ebenfalls umschlossen sein können oder unverkapselt sein können, d.h. außerhalb der ersten Verkapselungsschicht und der zweiten Verkapselungsschicht angeordnet sein können. Außerdem haften durch das Laminieren die Vorderseitenschicht und die Rückseitenschicht an den Verkapselungsschichten und bilden so den laminierten Schichtstapel.

Die Verkapselungsschichten können als Verkapselungsmaterialien Elastomere, wie z.B. Ethylen-Vinyl-Acetat, Polyurethan Gießharze, Polyacrylat Gießharze oder zwei-komponentige Silikone, oder thermoplastische Kunststoffe, wie Polyvinylbutyral, thermoplastisches Polyurethan, lonoplaste oder modifizierte Polyolefine umfassen oder aus diesen bestehen. Unter Laminieren kann daher ein thermisch-, chemisch- oder strahlungs-induziertes stoffschlüssiges Fügen der Verkapselungsschichten verstanden werden.

In Ausführungsformen können die erste und bzw. die zweite Verkapselungsschicht auch integrierte Leiterstrukturen enthalten, die der elektrischen Verbindung der Solarzellen oder Solarmodule in den mindestens zwei Strings in Reihe oder elektrisch parallel zueinander und der elektrischen Verbindung der mindestens zwei Strings mit den jeweils endseitig angeordneten Kontaktflächen dienen.

Die Vorderseitenschicht kann aus einer oder mehreren Kunststoffschichten und bzw. oder einer Glasschicht bestehen. Die Rückseitenschicht kann beispielsweise aus einer oder mehreren Kunststoffschichten oder einem Verbundwerkstoff bestehen, der z. B. metallische Schichten oder einen metallischen Kern umfassen kann. Außerdem können im jeweiligen Schichtstapel funktionale Zwischenschichten, beispielsweise zur Entspiegelung oder Haftvermittlung, vorgesehen sein.

Ein String aus Solarzellen oder Solarmodulen kann beispielsweise ausgebildet werden, indem die Solarzellen oder Solarmodule auf der ersten oder zweiten Verkapselungsschicht, vorzugsweise in einer Reihe, angeordnet werden und mit der Leiterstruktur elektrisch in Reihe oder parallel zueinander verbunden werden. Für die elektrische Kontaktierung der Solarzellen oder Solarmodule zu einem String kann die Leiterstruktur auf der Vorderseite und bzw. oder der Rückseite der Solarzellen bzw. der Solarmodule mit diesen elektrisch verbunden, z. B. verlötet, verschweißt oder mit einem elektrisch leitfähigen Kleber befestigt, werden. Vorteilhaft können die Strings aus Rückseitenkontakt-Solarzellen vom Typ MWT (Metal Wrap Through), EWT (Emitter Wrap Through) oder IBC (Interdigitated Back Contact) gebildet werden, um vorderseitige Abschattung durch die Leiterstrukturen zu vermeiden.

In Ausführungsformen können die Solarzelle oderSolarmodule schräg zur Ebene des laminierten Schichtstapels angeordnet sein und einander zur elektrischen Kontaktierung überlappen um einen String zu bilden, sodass nur an den Enden der Strings jeweils eine Leiterstruktur zur elektrischen Kontaktierung des Strings an den Solarzellen oder Solarmodulen angebracht ist. Das Verfahren kann also auch auf sogenannte lückenlose Strings angewendet werden

Die mindestens zwei Strings können parallel zu Außenkanten des laminierten Schichtstapels und bzw. oder in parallelen Reihen zueinander angeordnet werden, wobei die Solarzellen oder Solarmodule insbesondere in einer Matrix angeordnet werden können. In der Matrix, d. h. einer Anordnung aus Reihen und bzw. oder Zeilen, können die Solarzellen oder Module insbesondere gleichmäßig zueinander beabstandet sein.

Die Leiterstruktur, mit denen die Solarzellen oder Solarmodule zu Strings verbunden sind bzw. werden, kann aus einem Draht oder Drähten, insbesondere aus parallel zueinander angeordneten Drähten ausgebildet sein, die gleichmäßig zueinander beabstandet sein können. Die Kontaktflächen an den Enden der Strings können durch Abplatten, insbesondere durch Pressen, der Enden der Leiterstruktur gebildet sein bzw. werden. Dabei können beispielsweise mehrere Drähte einer Leiterstruktur eines Strings miteinander zu einer Kontaktfläche verbunden werden. Alternativ können Kontaktflächen durch Abscheiden von Metallen oder Aufkleben von Kontaktpads mit einem elektrisch leitfähigen Kleber gebildet werden. Die Kontaktflächen können typischerweise am Anfang und am Ende eines Strings angeordnet sein. In Ausführungsformen können auch Leiterstrukturen mehrerer Strings und bzw. oder Kontaktflächen mehrerer Strings miteinander zu Stromsammlern verbunden sein bzw. werden.

In Ausführungsformen wird der Rahmen des gerahmten Solarmoduls oder des gerahmten Solararrays durch ein Urformverfahren erzeugt, nachdem der Schaltungsträger und der Schichtstapel in eine Form eingelegt wurden. Dabei wird der Schaltungsträger in den erzeugten Rahmen integriert. Solch ein Urformverfahren ist bspw. ein Spritzgießverfahren oder ein Pressformverfahren, bei dem aus einem pulverförmigen Material zunächst eine Urform erzeugt wird, die anschließen durch Temperatureinwirkung verfestigt wird.

In anderen Ausführungsformen des Verfahrens enthält das Rahmenmodul eine erste Rahmenschale und eine zweite Rahmenschale, wobei der Schaltungsträger in die erste Rahmenschale und/oder in die zweite Rahmenschale integriert ist. Zum Rahmen wird der laminierte Schichtstapel zwischen der ersten Rahmenschale und der zweiten Rahmenschale angeordnet und die erste Rahmenschale und die zweite Rahmenschale werden zu einem Rahmen zusammengefügt. Unter der ersten Rahmenschale wird dabei diejenige Rahmenschale verstanden, die nach dem Fügen der Rahmenschalen die Vorderseitenschicht des laminierten Schichtstapels an deren äußerem Rand umschließt. Das Zusammenfügen der ersten Rahmenschale und der zweiten Rahmenschale zu einem Rahmen kann bevorzugt durch form- und bzw. oder kraftschlüssiges Fügen erfolgen, z. B. durch Druckfügen, Verpressen, Umformen, Verschrauben oder Verklemmen. Es ist alternativ oder zusätzlich aber auch ein stoffschlüssiges Fügen, z. B. durch Verschweißen, Verlöten oder Verkleben der Rahmenschalen, möglich. Für das Verklemmen können insbesondere lösbare Verbindungelemente, wie Clipverschlüsse bzw.

Rastnasen und Einrastnuten, an der ersten und bzw. oder zweiten Rahmenschale vorgesehen sein, wie sie aus dem Stand der Technik bekannt sind.

Dabei können die erste Rahmenschale und die zweite Rahmenschale vorteilhaft als in sich geschlossene Rahmenschalen, insbesondere als Rechteckrahmenschalen, ausgebildet sein. Besonders bevorzugt sind die erste Rahmenschale und bzw. die zweite Rahmenschale als monolithische Rahmenschalen ausgebildet, das heißt sie bestehen aus einem Stück. Dadurch können komplexe Verfahrensschritte, wie der Zusammenbau einzelner Bauteile zu einer Rahmenschale, entfallen und die Herstellung von gerahmten Solarmodulen bzw. -arrays beschleunigt werden.

In Ausführungsformen kann der laminierte Schichtstapel für das Zusammenfügen der ersten und zweiten Rahmenschalen zu einem Rahmen insbesondere in die erste Rahmenschale oder in die zweite Rahmenschale eingelegt werden. Einlegen bedeutet, dass der laminierte Schichtstapel mit mindestens einer der folgenden Schichten auf mindestens einer Auflagefläche der ersten oder zweiten Rahmenschale, die bevorzugt in einer Vertiefung in der ersten oder zweiten Rahmenschale ausgebildet ist, angeordnet bzw. aufgelegt wird: mit der Vorderseitenschicht, der ersten Verkapselungsschicht, der zweiten Verkapselungsschicht und der Rückseitenschicht.

Der laminierte Schichtstapel kann beispielsweise mit der Vorderseitenschichtund/oder der ersten Verkapselungsschicht an jeweils einer Auflagefläche in der ersten Rahmenschale angeordnet werden, wobei die Auflagefläche bzw. Auflageflächen um eine durchgehende Öffnung in der Vertiefung der ersten Rahmenschale gebildet ist. Anschließend kann die zweite Rahmenschale auf der ersten Rahmenschale und dem laminierten Schichtstapel angeordnet werden. Die Rückseitenschicht kann dabei an einer Auflagefläche der zweiten Rahmenschale angeordnet werden. Diese Auflagefläche kann an oder in einer Vertiefung der zweiten Rahmenschale ausgebildet sein, wobei die Vertiefung mit einem geschlossenen Boden, was einer rückseitig geschlossenen Rahmenschale entspricht, oder für eine bessere Temperierung und Hinterlüftung des laminierten Schichtstapels als eine durchgehende Öffnung oder mit einer durchgehenden Öffnung ausgebildet sein kann, was einer rückseitig offenen Rahmenschale entspricht. Alternativ kann der laminierte Schichtstapel mit der Rückseitenschicht auf der Auflagefläche der zweiten Rahmenschale angeordnet werden und die erste Rahmenschale auf dem laminierten Schichtstapel und der zweiten Rahmenschale angeordnet werden. Bei dieser Ausführungsform des Verfahrens sind also nur sehr wenige Positionierungsvorgänge durchzuführen, die dadurch erleichtert werden, dass die Rahmenschalen eine Führung für die Positionierung und Ausrichtung des laminierten Schichtstapels bewirken. Dies ermöglicht wiederum eine unkomplizierte Automatisierung des Verfahrens.

Vorteilhaft kann die Vertiefung, in der der laminierte Schichtstapel für das Zusammenfügen der ersten und zweiten Rahmenschale angeordnet wird, zumindest abschnittsweise kongruent zum laminierten Schichtstapel geformt sein. Insbesondere kann eine Innenkontur der Vertiefung der ersten und bzw. oder zweiten Rahmenschalen kongruent zu einer Außenkontur des laminierten Schichtstapels in der Ebene des Schichtstapels geformt sein.

In Ausführungsformen kann es vorgesehen sein, dass die Außenkanten, und somit die Randbereiche, der Rückseitenschicht, der ersten Verkapselungsschicht, der zweiten Verkapselungsschicht und bzw. oder der Vorderseitenschicht in der Ebene des laminierten Schichtstapels jeweils parallel zueinander versetzt ausgebildet sind, sodass die Außenkanten, und somit die Randbereiche, der jeweiligen Schichten beim Zusammenfügen der ersten und der zweiten Rahmenschalen jeweils an zueinander versetzt angeordneten Auflageflächen der ersten und bzw. oder zweiten Rahmenschale angeordnet sind. Durch mehrere Auflageflächen wird die Positionierung des laminierten Schichtstapels in den Rahmenschalen deutlich erleichtert.

In Ausführungsformen können beispielsweise die erste Verkapselungsschicht und die Vorderseitenschicht in der Ebene des laminierten Schichtstapels parallel zueinander versetzte Außenkanten bzw. Randbereiche aufweisen und die erste und die zweite Rahmenschalen derart ausgebildet sein, dass beim Zusammenfügen der ersten und der zweiten Rahmenschalen mindestens eine Außenkante bzw. ein Randbereich der Vorderseitenschicht an einer ersten Auflagefläche der ersten Rahmenschale und mindestens eine Außenkante bzw. ein Randbereich der ersten Verkapselungsschicht an einer zweiten Auflagefläche der ersten Rahmenschale angeordnet sind. Selbstverständlich ist eine Ausbildung des laminierten Schichtstapels in der beschriebenen Form auch bei Nutzung eines Urformverfahrens zur Erzeugung des Rahmens möglich.

In weiteren Ausführungsformen kann es vorgesehen sein, dass die Rückseitenschicht insbesondere derart ausgebildet ist, dass sie die Außenkanten der ersten Verkapselungsschicht, der zweiten Verkapselungsschicht, der Kontaktflächen und der Vorderseitenschicht überragt. Für den Fall, dass zum Erzeugen des Rahmens Rahmenschalen genutzt werden, so können de erste und die zweite Rahmenschalen derart ausgebildet sein, dass beim Zusammenfügen der ersten und der zweiten Rahmenschalen mindestens eine Außenkante bzw. ein Randbereich der Vorderseitenschicht an einer ersten Auflagefläche der ersten Rahmenschale und mindestens eine Außenkante bzw. ein Randbereich der Rückseitenschicht an einer dritten Auflagefläche der zweiten Rahmenschale angeordnet sind.

Für das Zusammenfügen der ersten und zweiten Rahmenschalen zu einem Rahmen können an der ersten Rahmenschale und der zweiten Rahmenschale Fügeflächen vorgesehen sein, die beim Zusammenfügen der Rahmenschalen in einem berührenden Kontakt zueinander angeordnet werden. Vorteilhaft sind die Fügeflächen umlaufend, insbesondere parallel zu mindestens einer Auflagefläche, um die Vertiefung in der ersten Rahmenschale und um die Vertiefung oder um eine durchgehende Öffnung in der zweiten Rahmenschale ausgebildet.

Für die elektrische Kontaktierung beim Zusammenfügen der Rahmenschalen können die Kontaktierungskontakte bevorzugt an Auflageflächen der ersten oder zweiten Rahmenschale angeordnet sein, an denen der laminierte Schichtstapel nach dem Zusammenfügen der Rahmenschalen mit mindestens einer der Vorderseitenschicht, der ersten Verkapselungsschicht, der zweiten Verkapselungsschicht oder der Rückseitenschicht in berührendem Kontakt angeordnet ist bzw. anliegt. Die Kontaktflächen können bei dem Verfahren bevorzugt in Randbereichen des laminierten Schichtstapels ausgebildet sein bzw. werden, die beim Zusammenfügen der ersten und zweiten Rahmenschale an Auflageflächen der ersten oder zweiten Rahmenschale angeordnet sind bzw. anliegen, wobei die Randbereiche selbstelektrisch isolierend ausgebildet sind. Die Kontaktflächen sind dabei in dem laminierten Schichtstapel, insbesondere zwischen der ersten und zweiten Verkapselungsschicht und bzw. oder auch an Außenkanten der ersten und zweiten Verkapselungsschicht angeordnet sein, wobei sie jedoch immer von mindestens einer der folgenden Schichten bedeckt sind: der Vorderseitenschicht, der ersten Verkapselungsschicht, der zweiten Verkapselungsschicht und der Rückseitenschicht Bevorzugt können Kontaktflächen parallel zu Außenkanten der ersten und zweiten Verkapselungsschicht angeordnet sein. Durch die Anordnung der Kontaktflächen in Bereichen des Schichtstapels, welche an bzw. auf Auflageflächen der Rahmenschalen an- bzw. aufliegen, wird bei der elektrischen Kontaktierung ein Durchbiegen des laminierten Schichtstapels verhindert oder zumindest vermindert, weil die jeweilige Auflagefläche eine Gegenkraft zum Kontaktierungsdruck bietet. Außerdem sind die Kontaktflächen durch die Auflageflächen nach außen hin verdeckt, sodass zum einen ein einheitlicheres Aussehen der Solarmodule bzw. -arrays erreicht wird und zum anderen auch ein Hitzeschutz durch eine Abschattung der Kontaktflächen bewirkt wird.

Die Kontaktierungskontakte können bevorzugtals Klemmen oder Schneidkontakte, insbesondere als Schneidbleche oder Kontaktierungsstifte, ausgebildet sein. Die Schneidbleche können mit einer keilförmigen Schneidkante ausgebildet sein. Die Kontaktierungsstifte können mit einer konisch zulaufenden Spitze ausgebildet sein. Schneidkontakte durchdringen die Kontaktflächen vollständig oder zumindest teilweise, d.h. dringen in die Kontaktflächen ein, und bilden einen formschlüssigen Kontakt zu diesen. Klemmen hingegen durchdringen die Kontaktflächen nicht, sondern liegen nur auf diesen auf, wobei der Kontakt durch die Anpresskraft des Rahmens erzeugt wird. Vorzugsweise wird der laminierte Schichtstapel durch die Kontaktierungskontakte nur so weit wie der Durchmesser der Kontaktierungskontakte geöffnet, sodass die Kontaktierungskontakte durch den umgebenden Schichtstapel, bspw. durch die jeweils durchdrungene Verkapselungsschicht, abgedichtet sind und eine Lagefixierung des Laminates und Zugfestigkeit der Verbindung erreicht wird. Alternativ können die Kontaktflächen ganz oder teilweise auch nicht von der ersten bzw. zweiten Verkapselungsschicht bedeckt sein, wie dies oben beschrieben ist.

Die Kontaktierungskontakte bestehen aus einem geeigneten, elektrisch leitfähigen Material, vorzugsweise aus Messing, Edelstahl, verzinntem Stahl oder anderen Metallen oder Verbindungen oder Gemischen oder Schichtaufbauten.

Die Kontaktierungskontakte können dabei den laminierten Schichtstapel im Wesentlich senkrecht zur Ebene des laminierten Schichtstapels zumindest bis zu den Kontaktflächen durchdringen und die Kontaktflächen im Wesentlichen senkrecht kontaktieren. Im Wesentlichen senkrecht bedeutet in diesem Zusammenhang in einem Winkel zwischen einschließlich 0° bis 45°, bevorzugt 0° bis 30°, zur Flächennormalen des laminierten Schichtstapels bzw. zur Flächennormalen der Kontaktflächen.

In Ausführungsformen können die Kontaktierungskontakte auch die Kontaktflächen durchdringen. Dadurch kann zum einen eine zusätzliche Lagefixierung des laminierten Schichtstapels im Rahmen bewirkt werden, zum anderen können aber auch Kontaktflächen, die in Bezug auf die Ebene des laminierten Schichtstapels vertikal versetzt zueinander angeordnet sind, kontaktiert werden.

Ein vertikaler Versatz der Kontaktflächen kann sich zum Beispiel dadurch ergeben, dass die Kontaktflächen an Solarzellen oder Solarmodulen unterschiedlicher Höhe oder an sich überlappenden, zur Ebene der Verkapselungsschichten schräg angeordneten Solarzellen oder Solarmodulen gebildet werden. Ein Versatz zwischen den Kontaktflächen kann typischerweise auch entstehen, wenn Kontaktflächen an den Enden nebeneinander angeordneter Strings in einem String an oder mit Leiterstrukturen an der Vorderseite der Solarzelle bzw. des Solarmoduls und im anderen String an oder mit Leiterstrukturen an der Rückseite der Solarzelle bzw. des Solarmoduls gebildet werden. Mit dem erfindungsgemäßen Verfahren können Abweichungen in der vertikalen Position der Kontaktflächen ohne weitere Positioniervorgänge beim Kontaktieren ausgeglichen werden.

In Ausführungsformen des Verfahrens können die Kontaktierungskontakte vor, während oder nach dem Erzeugen des Rahmens, z.B. durch Zusammenfügen der ersten und zweiten Rahmenschale, erhitzt werden, z.B. durch Induktionswärme. Die Temperatur der erhitzten Kontaktierungskontakte kann insbesondere höher sein als die Schmelztemperatur der jeweiligen Schichten, die beim Kontaktieren von den Kontaktierungskontakten durchdrungen werden. Dadurch können die Schichten zum Kontaktieren der Kontaktflächen aufgeschmolzen werden und beim Erkalten eine zusätzliche Abdichtung um die Kontaktierungskontakte bilden.

Die elektrische Schaltung des Rahmenmoduls kann für das erfindungsgemäße Verfahren ausgebildet sein, um die mindestens zwei Strings aus Solarzellen oder Solarmodulen elektrisch in Reihe oder parallel zueinander zu verschalten.

Die Erfindung betrifft ferner ein Rahmenmodul zur Herstellung eines gerahmten Solarmoduls oder eines gerahmten Solararrays aus einem laminierten Schichtstapel, der eine Vorderseitenschicht, eine erste Verkapselungsschicht, mindestens zwei Strings aus Solarzellen oder aus Solarmodulen, eine zweite Verkapselungsschicht und eine Rückseitenschicht aufweist, wobei die Solarzellen oder Solarmodule in den mindestens zwei Strings jeweils mit einer elektrisch leitfähigen Leiterstruktur, im Folgenden als Leiterstruktur bezeichnet, elektrisch in Reihe oder elektrisch parallel zueinander verbunden sind und an den mindestens zwei Strings jeweils endseitig eine elektrisch leitfähige Kontaktfläche, im Folgenden als Kontaktfläche bezeichnet, an der Leiterstruktur ausgebildet ist.

Das Rahmenmodul enthält einen Schaltungsträger mit einer elektrischen Schaltung und elektrisch leitfähigen Kontaktierungskontakten, sodass beim Erzeugen des Rahmens die elektrisch leitfähigen Kontaktierungskontakte den laminierten Schichtstapel, zumindest bis zu den elektrisch leitfähigen Kontaktflächen, durchdringen und jeweils mindestens eine elektrisch leitfähige Kontaktflächen elektrisch kontaktieren und einen elektrischen Kontakt zwischen den mindestens zwei Strings und der elektrischen Schaltung bilden.

In Ausführungsvarianten umfasst das Rahmenmodul eine erste Rahmenschale und eine zweite Rahmenschale, die zu dem Rahmen zusammenfügbar und derart ausgebildet sind, dass zwischen der ersten Rahmenschale und der zweiten Rahmenschale der laminierte Schichtstapel anordenbar ist. Der Schaltungsträger ist dabei in die erste Rahmenschale und bzw. oder die zweite Rahmenschale integriert ausgebildet, das heißt die erste und/oder die zweite Rahmenschale umfassen eine elektrische Schaltung und elektrisch leitfähige Kontaktierungskontakte, die im Folgenden als Kontaktierungskontakte bezeichnet werden. Die Kontaktierungskontakte sind derart ausgebildet, dass sie beim Zusammenfügen der ersten Rahmenschale und der zweiten Rahmenschale zu dem Rahmen den laminierten Schichtstapel, zumindest bis zu den Kontaktflächen, durchdringen und jeweils mindestens eine Kontaktfläche der mindestens zwei Strings elektrisch kontaktieren, sodass ein elektrischer Kontakt zwischen den mindestens zwei Strings und der elektrischen Schaltung gebildet ist.

Vorzugsweise können die erste Rahmenschale und die zweite Rahmenschale als in sich geschlossene Rahmenschalen, ausgebildet sein. In sich geschlossen bedeutet, dass die erste Rahmenschale und die zweite Rahmenschale ausgebildet sind, den laminierten Schichtstapel umlaufend an dessen Außenumfang oder einer Außenkante zu umschließen oder zumindest zu berühren. Die erste Rahmenschale kann dafür eine Vertiefung mit einer durchgehenden Öffnung aufweisen. Die Öffnungsmaße der Öffnung entsprechen typischerweise mindestens den Abmaßen der Anordnung der mindestens zwei Strings aus Solarzellen oder Solarmodulen, sodass für den Betrieb der Solarzellen oder Solarmodule Sonnenlicht durch die Öffnung auf die Solarzellen bzw. -module fallen kann.

Für die Rahmung rechteckförmiger laminierter Schichtstapel können die erste Rahmenschale und die zweite Rahmenschale insbesondere als Rechteckrahmenschalen ausgebildet sein. Die erste und bzw. oder zweite Rahmenschale können dafür eine rechteckförmige Vertiefung für den laminierten Schichtstapel aufweisen. Besonders vorteilhaft können die erste Rahmenschale und die zweite Rahmenschale jeweils als monolithische Bauteile ausgebildet sein, das heißt aus einem Stück bestehen, insbesondere aus einem Stück gefertigt oder gegossen, sein.

In Ausführungsformen kann die erste Rahmenschale für eine einfache Positionierung des laminierten Schichtstapels eine Vertiefung aufweisen, die im Wesentlichen kongruent zum laminierten Schichtstapel geformt ist. Die Vertiefung kann beispielsweise eine erste Auflagefläche für die Vorderseitenschicht und eine zweite Auflagefläche für die erste Verkapselungsschicht aufweisen. Die erste Auflagefläche und die zweite Auflagefläche können um die Schichtdicke der Vorderseitenschicht vertikal zur Ebene des laminierten Schichtstapels zueinander versetzt ausgebildet sein.

Weiterhin kann die zweite Rahmenschale eine dritte Auflagefläche aufweisen, an der nach dem Zusammenfügen der ersten und der zweiten Rahmenschale eine Außenkante, und somit ein Randbereich, der Rückseitenschicht anliegt bzw. angeordnet ist. Die dritte Auflagefläche kann bündig zu einer Fügefläche der zweiten Rahmenschale gebildet sein, an der die erste Rahmenschale und die zweite Rahmenschale nach dem Zusammenfügen in berührendem Kontakt zueinander angeordnet sind.

Der Abstand der zweiten Auflagefläche einer Fügefläche der ersten Rahmenschale, an der die erste Rahmenschale und die zweite Rahmenschale nach dem Zusammenfügen in berührendem Kontakt zueinander angeordnet sind, kann der Summe der Schichtdicken der Rückseitenschicht und der ersten und zweiten Verkapselungsschicht entsprechen, sodass die Rückseitenschicht beim Einlegen des laminierten Schichtstapels in die erste Rahmenschale mit ihrer Oberfläche bündig mit der ersten Rahmenschale, bzw. der Fügefläche zur zweiten Rahmenschale, abschließt. In alternativen Ausführungsformen kann es auch vorgesehen sein, dass der Abstand der zweiten Auflagefläche zur Fügefläche der ersten Rahmenschale geringer als die Summe der Schichtdicken der Rückseitenschicht und der ersten und zweiten Verkapselungsschicht ist, sodass die Rückseitenschicht beim Einlegen des laminierten Schichtstapels in die erste Rahmenschale mit ihrer Oberfläche über die ersten Rahmenschale, bzw. die Fügefläche zur zweiten Rahmenschale, übersteht. Die zweite Rahmenschale kann dann eine Vertiefung aufweisen, die kongruent zur Rückseitenschicht ausgebildet ist und die überstehende Rückseitenschicht beim Zusammenfügen der Rahmenschalen aufnimmt.

Die Auflageflächen können bevorzugt umlaufende Auflageflächen sein. Umlaufend bedeutet in diesem Zusammenhang, dass die Auflagefläche als, bevorzugt zusammenhängende, insbesondere planare, Fläche an einem Innenumfang der Vertiefung in der jeweiligen Rahmenschale gebildet ist. Alternativ zu zusammenhängenden Auflageflächen können auch Auflageflächen mit Unterbrechungen oder Vertiefungen in der Auflagefläche vorgesehene sein. Die Auflageflächen können beispielsweise nur an zwei einander gegenüberliegenden Innenseiten der Vertiefung in der ersten oder zweiten Rahmenschale vorgesehen sein. In weiteren Ausführungsformen kann mindestens eine Auflagefläche mit einem Oberflächenprofil ausgebildet sein, das kongruent geformt zu einem Profil an Außenkanten der jeweiligen Schicht, die beim Zusammenfügen der Rahmenschalen auf der Auflagefläche aufliegt, ausgebildet ist. Die Auflagefläche kann beispielsweise stufenartige, gewellte oder dreieckförmige Vertiefungen aufweisen, die beim Zusammenfügen der ersten und zweiten Rahmenschale in einen zinnenartig, wellenförmig oder gezackt geformten Randbereich des laminierten Schichtstapels greifen, sodass die Positionierung des laminierten Schichtstapels erleichtert wird.

Falls beispielsweise die Leiterstruktur und bzw. oder Kontaktflächen an den Enden der Strings außerhalb der ersten und zweiten Verkapselungsschicht angeordnet sind, können die stufenartigen Vertiefungen in der Auflagenfläche auch derart ausgebildet sein, dass vertikale Höhenunterschiede der Stufen einem vertikalen Versatz der Leiterstruktur und bzw. oder der Kontaktflächen in Bezug auf die Eben des laminierten Schichtstapels entsprechen.

Die Breite der Auflageflächen kann so gewählt sein, dass ein Randbereich des laminierten Schichtstapels, in denen keine Solarzellen oder Solarmodule angeordnet sind, nach dem Zusammenfügen der ersten Rahmenschale und der zweiten Rahmenschale an den Auflageflächen aufliegen, d. h. von diesen verdeckt sind.

In Ausführungsformen können die Seitenflächen der Vertiefung in der ersten und bzw. zweiten Rahmenschale, in die der laminierte Schichtstapel eingelegt bzw. angeordnet wird, derart ausgebildet sein, dass sie nach dem Zusammenfügen der ersten und der zweiten Rahmenschale ein Spaltmaß zu den Randbereichen der Rückseitenschicht, der ersten Verkapselungsschicht, der zweiten Verkapselungsschicht und bzw. oder der Vorderseitenschicht aufweisen. Dadurch kann ein passgenaues Zuschneiden des laminierten Schichtstapels für die Herstellung des Solarmoduls bzw. -arrays entfallen und das Verfahren vereinfacht werden. Unter Seitenflächen der Vertiefung sind dabei Innenflächen, d.h. Flächen am Innenumfang, der Vertiefung zu verstehen, die nach dem Zusammenfügen der Rahmenschalen vertikal zur Ebene des Schichtstapels angeordnet sind.

Die Vertiefung in der ersten Rahmenschale kann insbesondere derart ausgebildet sein, dass nach dem Zusammenfügen der ersten und der zweiten Rahmenschale im Bereich der ersten Verkapselungsschicht und der zweiten Verkapselungsschicht ein größeres Spaltmaß zwischen den Seitenflächen der Vertiefung und dem laminierten Schichtstapel ausgebildet ist als in Bereichen der Rückseitenschicht und der Vorderseitenschicht. Durch das erhöhte Spaltmaß im Bereich der ersten Verkapselungsschicht und der zweiten Verkapselungsschicht können Materialverschiebungen der Verkapselungsschichten beim Kontaktieren der Kontaktflächen oder auch bei Temperaturschwankungen ausgeglichen werden.

In weiteren Ausführungsformen kann das Spaltmaß zwischen der Rückseitenschicht und den Seitenflächen der Auflagefläche, an der nach dem Zusammenfügen der Rahmenschalen die Rückseitenschicht angeordnet ist bzw. aufliegt, und bzw. oder das Spaltmaß zwischen der Vorderseitenschicht und den Seitenflächen der Auflagefläche, an der nach dem Zusammenfügen der Rahmenschalen die Vorderseitenschicht angeordnet ist bzw. aufliegt, insbesondere kleiner sein als die Breite der Kontaktflächen. Dadurch können die Kontaktierungskontakte, selbst wenn sich der laminierte Schichtstapel in der Rahmenschale verschiebt, beim Zusammenfügen der Rahmenschalen noch auf die Kontaktflächen treffen.

Für die elektrische Kontaktierung der Kontaktflächen können die Kontaktierungskontakte bevorzugt an den Auflageflächen der ersten oder zweiten Rahmenschale angeordnet sein, auf denen der laminierte Schichtstapel nach dem Zusammenfügen der ersten und zweiten Rahmenschale mit der ersten Verkapselungsschicht oder der Rückseitenschicht in berührendem Kontakt angeordnet ist. Die Kontaktierungskontakte können dabei im Wesentlichen senkrecht zu den Auflageflächen angeordnet sein, sodass sie den laminierten Schichtstapel für die elektrische Kontaktierung im Wesentlichen senkrecht durchdringen und die Kontaktflächen im Wesentlichen senkrecht kontaktieren.

Die Kontaktierungskontakte können beispielsweise an der zweiten Rahmenschale angeordnet sein und beim Zusammenfügen der ersten und zweiten Rahmenschale die Rückseitenschicht und/oder die zweite Verkapselungsschicht durchdringen. Alternativ oder zusätzlich können Kontaktierungskontakte an der ersten Rahmenschale angeordnet sein und beim Zusammenfügen der ersten und zweiten Rahmenschale die erste Verkapselungsschicht und/oder die Vorderseitenschicht durchdringen.

Bevorzugt können die Kontaktierungskontakte als Schneidklemmen oder Schneidkontakte, insbesondere als Schneidbleche oder Kontaktierungsstifte, ausgebildet sein. Die Schneidbleche können dabei mit einer keilförmigen Schneidkante ausgebildet sein. Die Kontaktierungsstifte können mit einer konisch zulaufenden Spitze ausgebildet sein. Die Länge einer Schneidkante kann der Länge einer Kontaktfläche eines Strings oder eines Stromsammlers entsprechen. Unter der Länge einer Kontaktfläche ist dabei eine maximale Ausdehnung der Kontaktfläche parallel zur Ebene des laminierten Schichtstapels zu verstehen.

Die jeweilige Länge der Kontaktierungskontakte, mit der die Kontaktierungskontakte den laminierten Schichtstapel durchdringen, kann wenigstens den Abstand zwischen einer Kontaktfläche, die mit dem jeweiligen Kontaktierungskontakt beim Erzeugen des Rahmens kontaktiert wird, und der Oberfläche des laminierten Schichtstapels, an der der laminierte Schichtstapel von dem jeweiligen Kontaktierungskontakt beim Erzeugen des Rahmens durchdrungen wird, betragen. Wird der laminierte Schichtstapel beispielsweise an der Rückseitenschicht durchdrungen, so kann die Länge der Kontaktierungskontakte wenigstens dem Abstand zwischen der Außenfläche der Rückseitenschicht und der jeweiligen Kontaktflächen betragen. Die Länge der Kontaktierungskontakte kann insbesondere größer als der bezeichnete Abstand sein, sodass die Kontaktierungskontakte nicht nur in einen berührenden Kontakt mit der jeweiligen Kontaktfläche gebracht werden, sondern in diese eindringen oder diese auch vollständig durchdringen, wodurch eine zusätzliche Lagefixierung des laminierten Schichtstapels im Rahmen bewirkt wird. Die maximale Länge der Kontaktierungskontakte kann typischerweise so gewählt sein, dass die Kontaktierungskontakte den laminierten Schichtstapel nicht vollständig durchdringen, insbesondere derart, dass die Kontaktierungskontakte jeweils nur eine der Verkapselungsschichten vollständig durchdringen.

In Ausführungsformen kann insbesondere die Länge sämtlicher Kontaktierungskontakte, mit der die Kontaktierungskontakte den laminierten Schichtstapel durchdringen, wenigstem dem maximalen Abstand zwischen den Kontaktflächen und der Oberfläche des laminierten Schichtstapels, an der der laminierte Schichtstapel von den Kontaktierungskontakten zum elektrischen Kontaktieren der Kontaktflächen beim Erzeugen des Rahmens durchdrungen wird, betragen. Dadurch dass sämtliche Kontaktierungskontakte mindestens den maximalen Abstand zwischen den Kontaktflächen und der Oberfläche des laminierten Schichtstapels durchdringen können, können sämtliche Kontaktflächen, auch wenn sie im laminierten Schichtstapel vertikal zueinander versetzt sind, elektrisch kontaktiert werden und Abweichungen in der vertikalen Position der Kontaktflächen mit dem Verfahren einfach ausgeglichen werden.

In Ausführungsformen können die Kontaktierungskontakte ausgebildet sein, jeweils mehrere in Bezug auf die Ebene des laminierten Schichtstapels vertikal übereinander angeordnete Kontaktflächen zu kontaktieren. Die Kontaktflächen können beispielsweise Kontaktflächen, insbesondere überlappende Kontaktflächen, verschiedener, insbesondere nebeneinander angeordneter, Strings, Solarzellen oder Solarmodule sein. Dadurch können mit dem Rahmenmodul dreidimensionale Verschaltungen zwischen Solarzellen oder Solarmodulen bzw. Strings aus Solarzellen oder Solarmodulen ausgebildet werden.

Für eine einfache Fertigung von gerahmten Solarmodulen oder -arrays kann bzw. können die erste Rahmenschale und bzw. oder die zweite Rahmenschale bevorzugt als schaltungsintegrierte Schaltungsträger ausgebildet sein. Schaltungsintegriert bedeutet, dass die elektrische Schaltung in einer Oberfläche und bzw. oder an einer Oberfläche der ersten und bzw. oder zweiten Rahmenschale angeordnet ist, wobei die Oberfläche elektrisch isolierend ist. Unter einer Schaltung ist dabei ein elektrischer Zusammenschluss von elektrischen bzw. elektromechanischen Bauelementen zu verstehen. Die elektrische Schaltung kann beispielsweise in die erste und bzw. oder zweite Rahmenschale eingelassen oder eingegossen und bzw. oder auf diese abgeschieden oder aufgedruckt sein. Die Rahmenschale bzw. -schalen stellen somit die Leiterplatte für die elektrische Schaltung dar, sodass keine zusätzlichen Leiterplatten verwendet müssen. Die Kontaktierungskontakte können ebenfalls an oder in einer elektrisch isolierenden Oberfläche der ersten und bzw. oder zweite Rahmenschale befestigt sein, z.B. eingelassen, eingegossen, verklebt oder verschraubt sein. Elektrisch isolierend bedeutet, dass die Oberfläche einen elektrischen Widerstand von mindestens 5×10⁴ Ω, bevorzugt mindestens 10⁹ Ω,, besonders bevorzugt mindestens 5×10¹¹ Ω, aufweist.

In Ausführungsformen kann bzw. können der Schaltungsträger des Rahmenmoduls und/oderdie erste Rahmenschale und bzw. oder die zweite Rahmenschale vorteilhaft aus einem elektrisch isolierendem Material, wie Kunststoff, insbesondere einem Thermoplast, bestehen. Rahmenschalen aus Kunststoff können beispielsweise in einem Warmpressverfahren oder einem Kunststoffgussverfahren hergestellt sein. Bevorzugt kann bzw. können die erste Rahmenschale und bzw. oder die zweite Rahmenschale in einem Mehrkomponentenspritzgussverfahren, insbesondere in einem Printed-Circuit-Board-Kollmorgen-Verfahren (PCK-Verfahren) oder einem Sankyo-Kasei-Wiring-Board-Verfahren (SKW-Verfahren), hergestellt sein. Die elektrische Schaltung und Kontaktierungskontakte können dabei in die jeweilige Rahmenschale eingebettet bzw. eingegossen sein. Mit derartigen MID-Rahmenschalen (Molded Interconnect Device) kann gegenüber herkömmlichen Anschlussdosen, die aus einem Gehäuse und separaten Leiterplatten bestehen, die Anzahl an Teilen und verschiedenen Materialien reduziert werden. Damit lässt sich der Montageaufwand bei der Herstellung von gerahmten Solarmodulen oder -arrays erheblich senken, aber auch die Recyclebarkeit und die elektrische Durchschlagfestigkeit der Solarmodule oder -arrays verbessern.

In weiteren Ausführungsformen kann bzw. können die erste Rahmenschale und bzw. oder die zweite Rahmenschale aus einem Verbundwerkstoff oder aus Metall, insbesondere aus Aluminium, bestehen. Rahmenschalen aus Metall können insbesondere in einem Tiefziehverfahren oder Metallgussverfahren hergestellt sein. Die elektrische Schaltung und bzw. oder Kontaktierungskontakte kann bzw. können in die erste und bzw. oder zweite Rahmenschale eingelassen, beispielsweise in Vertiefungen eingeklebt, eingegossen, eingepresst oder eingeschraubt sein. Dabei kann bzw. können die elektrische Schaltung und bzw. oder die Kontaktierungskontakte bei Rahmenschalen aus Metall zur elektrischen Isolierung auf einer elektrisch isolierenden Leiterplatte angeordnet sein oder mit einem elektrisch isolierenden Kleber oder einer elektrisch isolierenden Vergussmasse an oder in einer Oberfläche der Rahmenschale befestigt sein. Bei Rahmenschalen aus einem Verbundwerkstoff kann es vorgesehen sein, dass die Oberfläche des Verbundwerkstoffs, an und bzw. oder in der die elektrische Schaltung und bzw. oder die Kontaktierungskontakte befestigt sind, aus einem elektrisch isolierenden Material, z.B. aus Kunststoff, ausgebildet ist. In Ausführungsformen können die erste und die zweite Rahmenschale insbesondere auch aus unterschiedlichen Materialen bestehen, z.B. eine Rahmenschale aus Kunststoff und die andere aus Metall oder Verbundstoff.

Die elektrische Schaltung des Rahmenmoduls kann ausgebildet sein, die mindestens zwei Strings elektrisch in Reihe oder parallel zueinander zu verschalten. Die Kontaktierungskontakte können dafür insbesondere in einem Abstand zueinander angeordnet sein, der dem Abstand der Kontaktflächen im laminierten Schichtstapel entspricht. Die Kontaktierungskontakte können für die Verschaltung der Strings in der ersten oder zweiten Rahmenschale, z. B. über Drähte oder Stromsammelschienen, elektrisch miteinander und bzw. oder mit Bauelemente der elektrischen Schaltung verbunden sein.

Für eine Reihenschaltung können die Strings beispielsweise gegenpolig zueinander angeordnet sein, sodass die jeweils gegenpoligen Kontaktflächen der Strings nebeneinander angeordnet sind und mit den Kontaktierungskontakten und einer elektrischen Verbindung zwischen den Kontaktierungskontakten in der elektrischen Schaltung des Schaltungsträgers miteinander verschaltet werden können. Für eine Parallelschaltung der Strings können die Strings jeweils gleichnamig gepolt zueinander angeordnet sein, sodass die jeweils gleichnamig gepolten Kontaktflächen der Strings nebeneinander angeordnet sind und mit den Kontaktierungskontakten und einer elektrischen Verbindung zwischen den Kontaktierungskontakten in der elektrischen Schaltung des Schaltungsträgers miteinander verschaltet werden können.

In Ausführungsformen kann es vorgesehen sein, dass die elektrische Schaltung des Rahmenmoduls Bypass-Dioden und bzw. oder Sperrdioden zur Vermeidung von Überhitzungen durch Verschattung aufweist. Bypass-Dioden können parallel geschaltet zu einem String und bzw. oder parallel geschaltet zu einzelnen Solarzellen oder Solarmodulen vorgesehen sein. Sperrdioden können jeweils in Reihe zu einem String geschaltet sein.

Die elektrische Schaltung des Rahmenmoduls kann außerdem mindestens einen Wechselrichter zur Umwandlung eines Gleichstroms der mindestens zwei Strings in Wechselstrom, eine Sensorik für die Regelung des Betriebs des Solarmoduls oder des Solararrays, mindestens einen Akkumulator zur Energiespeicherung und bzw. oder einen Laderegler für den mindestens einen Akkumulator in der elektrischen Schaltung oder für einen externen Akkumulator aufweisen.

Des Weiteren kann die elektrische Schaltung einen Maximum Power Point Tracker (MPP-Tracker) aufweisen. Der MPP-Tracker kann insbesondere in den mindestens einen Wechselrichter oder in einen Laderegler integriert sein.

Enthält das Rahmenmodul Rahmenschalen, so können in Ausführungsformen weitere Vertiefungen oder Hohlräume in der ersten Rahmenschale und bzw. oder der zweiten Rahmenschale für eine Integration von Bauelementen der elektrischen Schaltung, insbesondere des Wechselrichters, der Sensorik, des Akkumulators oder des Ladereglers, für eine Integration weiterer Komponenten für den Betrieb des Solarmoduls oder-arrays, für eine Kabelführung oder auch zur Gewichtsreduzierung vorgesehen sein. Die erste Rahmenschale und bzw. oder die zweite Rahmenschale können insbesondere als Hohlprofile ausgebildet sein. Die weiteren Vertiefungen können vorteilhaft an einer Fügefläche zwischen der ersten und zweiten Rahmenschale ausgebildet sein, sodass sie beim Öffnen des Rahmenmoduls zugängig sind.

In Ausführungsformen kann das Rahmenmodul, insbesondere wenn es Rahmenschalen aufweist, ein erstes Dichtelement zur Abdichtung des erzeugten Rahmens, insbesondere der ersten Rahmenschale, gegen die Vorderseitenschicht und bzw. oder ein zweites Dichtelement zur Abdichtung des erzeugten Rahmens, insbesondere der zweiten Rahmenschale, gegen die Rückseitenschicht und bzw. oder ein drittes Dichtelement zur Abdichtung der ersten Rahmenschale gegen die zweite Rahmenschale aufweisen. Die Dichtelemente können insbesondere Dichtschüre sein, die jeweils in eine, bevorzugt umlaufende, Nut der Rahmenschalen oder des laminierten Schichtstapels eingelegt sind bzw. werden. Alternativ zu Dichtschnüren kann auch eine Dichtmasse als Dichtelement verwendet werden.

Die Abdichtung der ersten Rahmenschale gegen die Vorderseitenschicht kann beispielsweise an der ersten Auflagefläche der ersten Rahmenschale vorgesehen sein, an der die Vorderseitenschicht nach Zusammenfügen der ersten und zweiten Rahmenschale mit der ersten Rahmenschale in berührendem Kontakt ist. Die Abdichtung der ersten Rahmenschale gegen die zweite Rahmenschale kann an der Fügefläche zwischen der ersten und zweiten Rahmenschale vorgesehen sein, an der die Rahmenschalen nach dem Zusammenfügen in berührendem Kontakt zueinander sind. Die Abdichtung der zweiten Rahmenschale gegen die Rückseitenschicht kann an der dritten Auflagefläche der zweiten Rahmenschale vorgesehen sein, an der die Rückseitenschicht mit der zweiten Rahmenschale nach Zusammenfügen der ersten und zweiten Rahmenschale in berührendem Kontakt ist. Durch die Abdichtungen kann ein weiteres Verkleben oder Versiegeln des gerahmten Solarmoduls bzw. -arrays auch bei Nutzung von zwei Rahmenschalen entfallen und die Herstellung von gerahmten Solarmodulen oder -arrays weiter vereinfach werden. Die Abdichtungen mit Dichtschnüren erlauben insbesondere eine lösbare Verbindung der ersten und der zweiten Rahmenschale, sodass die Reparaturfähigkeit des Solarmoduls bzw. des Solararrays verbessert wird.

Für eine lösbare Verbindung der Rahmenschalen können an der ersten und bzw. oder zweiten Rahmenschale lösbare Verbindungelemente, wie z.B. Clipverschlüsse bzw. Rastnasen und Einrastnuten vorgesehen sein. Diese können besonders vorteilhaft an Rahmenschalen aus Kunststoff, insbesondere an spritzgegossenen schaltungsintegrierten Schaltungsträgern, ausgebildet sein.

In weiteren Ausführungsformen kann bzw. können die erste Rahmenschale und bzw. oder de zweite Rahmenschale an einem Außenumfang eine abgeflachte Oberkante oder eine abgeflachte Unterkante zur Stapelung der ersten und zweiten Rahmenschalen aufeinander aufweisen.

Das erfindungsgemäße Rahmenmodul kann für die Herstellung eines gerahmten Solarmoduls oder eines gerahmten Solararrays verwendet werden. Insbesondere kann das beschriebene Verfahren mit dem beschriebenen Rahmenmodul durchgeführt werden, das heißt das beschriebene Rahmenmodul ist zur Durchführung des beschriebenen Verfahrens geeignet und kann die im Verfahren beschriebenen Merkmale aufweisen.

Weiterhin betrifft die Erfindung ein gerahmtes Solarmodul oder ein gerahmtes Solararray aufweisend ein erfindungsgemäßes Rahmenmodul.

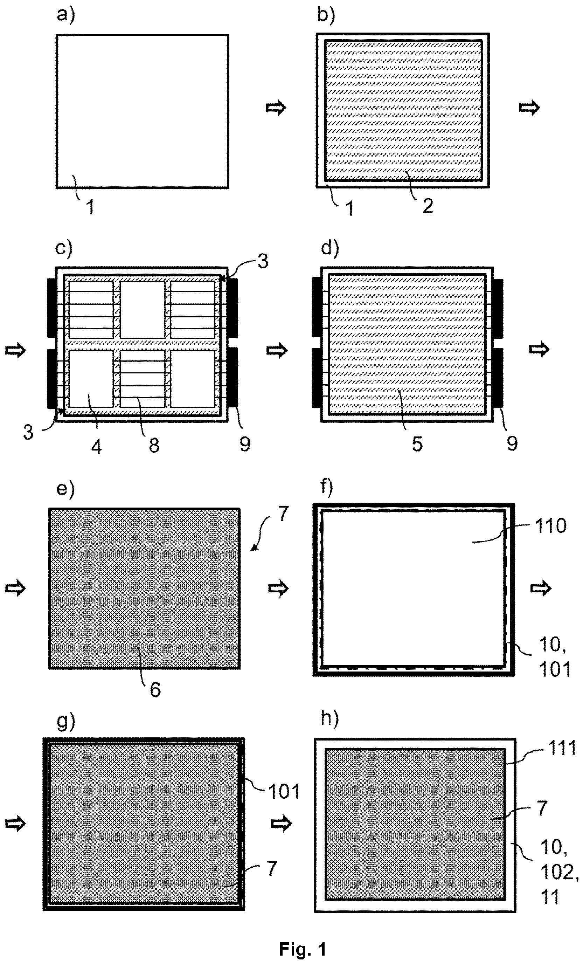

Ausführungsbeispiele der Erfindung sind in den Zeichnungen dargestellt und werden nachfolgend anhand der Figuren 1 bis 6 erläutert. Die Darstellung einzelner Merkmale in einer spezifischen Merkmalskombination schließt weitere Kombination der Merkmale nicht aus, d. h. die Merkmale sind miteinander kombinierbar, sofern sich die Merkmale nicht gegenseitig ausschließen oder eine spezifische Kombination von Merkmalen nicht explizit ausgeschlossen ist.

In den Abbildungen zeigt:
- Fig. 1:: schematisch ein Beispiel des erfindungsgemäßen Verfahrens zur Herstellung eines gerahmten Solarmoduls oder eines gerahmten Solararrays, wobei das Rahmenmodul zwei Rahmenschalen aufweist,
- Fig. 2a:: schematisch einen Querschnitt eines Beispiels eines Rahmenmoduls aufweisend zwei Rahmenschalen,
- Fig. 2b:: schematisch einen Teil eines Querschnittes eines mit Hilfe des Rahmenmoduls der Fig. 2a erzeugten gerahmten Solarmoduls,
- Fig. 3a:: schematisch einen Querschnitt eines Beispiels eines Rahmenmoduls aufweisend eine Folie als Schaltungsträger,
- Fig. 3b:: schematisch eine Draufsicht auf das Rahmenmodul der Fig. 3a,
- Fig. 3c:: schematisch einen Teil eines Querschnittes eines mit Hilfe des Rahmenmoduls der Fig. 3a erzeugten gerahmten Solarmoduls,
- Fig. 4:: schematisch ein Beispiel eines Rahmenmoduls und einer elektrischen Reihenschaltung von Strings mit in Reihe geschalteten Solarzellen bzw. -modulen,
- Fig. 5:: schematisch ein Beispiel eines Rahmenmoduls und einer elektrischen Parallelschaltung von Strings mit in Reihe geschalteten Solarzellen bzw. -modulen,
- Fig. 6:: schematisch ein Beispiel eines Rahmenmoduls und einer elektrischen Reihenschaltung von Strings mit parallel geschalteten Solarzellen bzw. -modulen, und
- Fig. 7:: schematisch ein Beispiel eines Rahmenmoduls und einer elektrischen Parallelschaltung von Strings mit parallel geschalteten Solarzellen bzw. -modulen.

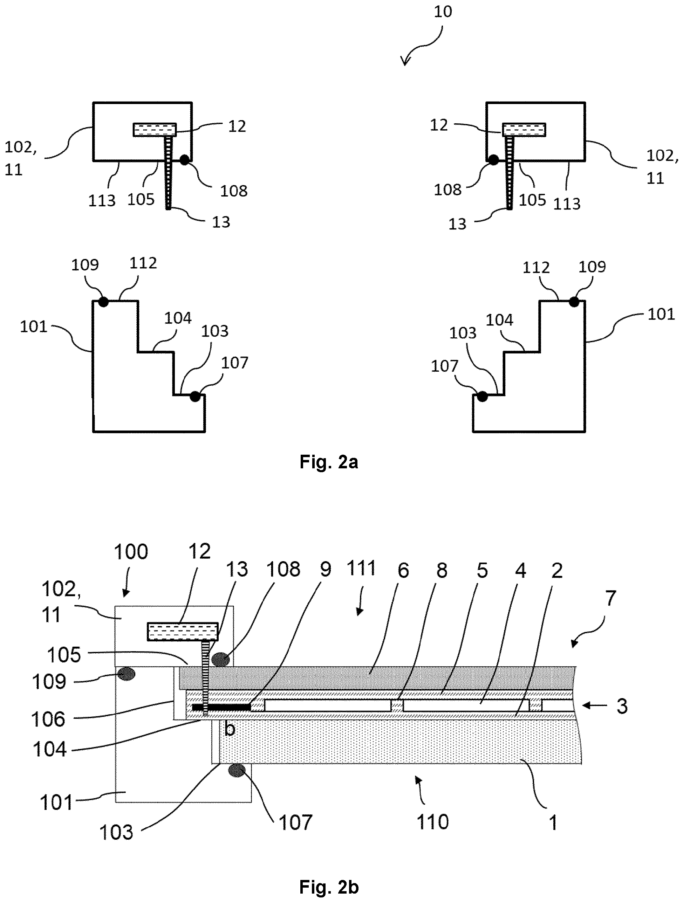

In Figur 1 ist schematisch an einem Beispiel das erfindungsgemäße Verfahren zur Herstellung eines gerahmten Solarmoduls oder eines gerahmten Solararrays dargestellt. In diesem Beispiel umfasst ein dabei verwendetes Rahmenmodul zwei Rahmenschalen, wobei besondere Merkmale der Rahmenschalen in den Figuren 2a und 2b dargestellt sind.

Bei dem Verfahren wird, wie im Schritt e) der Figur 1 dargestellt, ein laminierter Schichtstapel 7 aus einer Vorderseitenschicht 1, einer ersten Verkapselungsschicht 2, mindestens zwei Strings 3 aus Solarzellen 4 oder mindestens zwei Strings 3 aus Solarmodulen 4, einer zweiten Verkapselungsschicht 5 und einer Rückseitenschicht6 bereitgestellt. In diesem laminierten Schichtstapel 7 sind die Solarzellen 4 oder Solarmodule 4 in den mindestens zwei Strings 3 jeweils mit einer Leiterstruktur 8 elektrisch miteinander verbunden. In Figur 1 ist beispielhaft eine Reihenschaltung der Solarzellen 4 oder Solarmodule 4 in jedem der Strings 3 dargestellt, es sind jedoch auch Parallelschaltungen der Solarzellen 4 oder Solarmodule 4 in den Strings 3 möglich. Weiterhin ist in dem laminierten Schichtstapel 7 an jedem der mindestens zwei Strings 3 jeweils endseitig an der Leiterstruktur 8 des Strings 3 eine Kontaktfläche 9 ausgebildet.

Der laminierte Schichtstapel 7 ist derart laminiert, dass die mindestens zwei Strings 3 und die Leiterstrukturen 8 von der ersten Verkapselungsschicht 2 und der zweiten Verkapselungsschicht 5 umgeben sind. Die Kontaktflächen 9 können ebenfalls von der ersten Verkapselungsschicht 2 und der zweiten Verkapselungsschicht 5 umgeben sein, wie in Fig. 2b dargestellt, oder außerhalb der Verkapselungsschichten 2, 5, z.B. an Außenkanten, d.h. an Randbereichen, der ersten Verkapselungsschicht 2 und der zweiten Verkapselungsschicht 5, insbesondere in berührendem Kontakt zu diesen, angeordnet sein, wie in Fig. 1 dargestellt. In jedem Fall sind die Kontaktflächen 9 jedoch von mindestens einer der folgenden Schichten überdeckt: der Vorderseitenschicht 1, der ersten Verkapselungsschicht 2, der zweiten Verkapselungsschicht 5 und der Rückseitenschicht 6. In dem in Fig. 1 dargestellten Fall überdeckt nur die Rückseitenschicht 6 die Kontaktflächen 9.

Ein laminierter Schichtstapel 7 kann beispielsweise, wie in den Schritten a) bis d) der Figur 1 schematisch abgebildet, hergestellt werden, indem auf der Vorderseitenschicht 1, die erste Verkapselungsschicht 2 angeordnet wird, auf der die mindestens zwei Strings 3 aus Solarzellen 4 oder Solarmodulen 4 ausgebildet werden. Auf der ersten Verkapselungsschicht2 und den Strings 3 wird die zweite Verkapselungsschicht 5 und darauf die Rückseitenschicht 6 angeordnet. Der Schichtstapel kann jedoch auch in umgekehrter Reihenfolge der Schichten gebildet werden. Anschließend wird der Schichtstapel laminiert, wodurch die erste Verkapselungsschicht2 und die zweite Verkapselungsschicht 5 aneinander haften, aber auch die erste Verkapselungsschicht2 an der Vorderseitenschicht 1 und die zweiten Verkapselungsschicht 5 an der Rückseitenschicht 6 haften, sodass ein zusammenhängender Schichtstapel, der als laminierter Schichtstapel 7 bezeichnet wird, gebildet wird.

Ein String 3 aus Solarzellen 4 oder Solarmodulen 4 kann beispielsweise ausgebildet werden, indem die Solarzellen 4 oder Solarmodule 4 auf der ersten Verkapselungsschicht2 oder der zweiten Verkapselungsschicht 5 angeordnet werden und mit der Leiterstruktur8 elektrisch in Reihe oder parallel zueinander verbunden werden. Die mindestens zwei Strings 3 können beispielsweise, wie im Schritt c) der Figur 1 dargestellt, parallel zu Außenkanten des laminierten Schichtstapels 7 und in parallelen Reihen in einer Matrix ausgebildet werden. Es sind jedoch auch andere Anordnungen möglich.

Für die elektrische Kontaktierung der Solarzellen 4 oder Solarmodule 4 zu einem String 3 kann die Leiterstruktur 8 auf der Vorderseite und bzw. oder der Rückseite der Solarzellen 4 bzw. der Solarmodule 4 mit diesen elektrisch verbunden, z. B. verlötet oder mit einem elektrisch leitfähigen Kleber befestigt, werden. Vorteilhaft können die Strings 3 aber auch aus Rückseitenkontakt-Solarzellen vom Typ MWT (Metal Wrap Through), EWT (Emitter Wrap Through) oder IBC (Interdigitated Back Contact) gebildet werden.

Die Leiterstruktur 8, mit denen die Solarzellen 4 oder Solarmodule 4 zu Strings 3 verbunden sind bzw. werden, kann aus einem oder mehreren Drähten bestehen, z.B. Kupferdrähten, die gleichmäßig zueinander beabstandet sein können. Die Kontaktflächen 9 an den Enden der Strings 3 können durch Abplatten, insbesondere durch Pressen, der Enden der jeweiligen Leiterstruktur 8 am Ende eines Strings 3 gebildet sein bzw. werden. Dabei können beispielsweise mehrere Drähte einer Leiterstruktur 8 eines Strings 3 miteinander zu einer Kontaktfläche 9 verbunden werden. Alternativ können die Kontaktflächen 9 durch Abscheiden von Metallen oder Aufkleben von Kontaktpads mit einem Kleber gebildet und an ihnen die Leiterstruktur8 verbunden werden.

Die Vorderseitenschicht 1 kann bspw. aus Glas mit einer Dicke im Bereich von 1 mm bis 4 mm bestehen oder aus einer 0,5 mm bis 4 mm dicken Kunststoffschicht aus beispielsweise glasfaserverstärktem Kunststoff, Die erste Verkapselungsschicht 2 und die zweite Verkapselungsschicht 5 können bspw. aus POE (polyolefin elastomer), TPO (thermoplastic polyolefin), EVA (Ethylenvinylacetat), PVB (Polyvinylbutyral), EPE (EVA/polyester multi-layer) bestehen, die nach dem Laminieren eine Dicke im Bereich von 10 µm bis 1 mm aufweist. Die Rückseitenschicht 6 kann bspw. aus Glas mit einer Dicke im Bereich von 1 mm bis 4 mm oder aus einer oder mehreren Kunststoff- oder Metall-Kunststofffolien mit einer jeweiligen Dicke im Bereich von 20 µm bis 800 µm bestehen. Übliche Materialien für solch eine Rückseitenschicht aus Kunststofffolie sind beispielsweise PET (Polyethylenterephthalat), PVF (Polyvinylfluorid), PVDF (Polyvinylidenfluorid), PA (Polyamid), FEVE (Fluoroethylenevinylether), PEVA (PolyEthylen-Vinylacetat) und PTFE (Polytetrafluorethylen) oder Kombinationen aus einem oder mehreren dieser Materialien.

Nach dem Bereitstellen des laminierten Schichtstapels 7 wird der laminierte Schichtstapel 7 zwischen einer ersten Rahmenschale 101 und einer zweiten Rahmenschale 102 eines Rahmenmoduls 10 angeordnet. Dies kann beispielsweise wie in den Schritten f) bis h) der Figur 1 durchgeführt werden. Dabei wird zunächst das Rahmenmodul 10 bereitgestellt, wobei in Schritt f) zunächst nur die erste Rahmenschale 101 zu sehen ist. In diese wird in Schritt g) der laminierte Schichtstapel7 eingelegt, sodass der laminierte Schichtstapel7, insbesondere mit der Vorderseitenschicht 1, in berührendem Kontakt mit mindestens einer Auflagefläche der ersten Rahmenschale 101 ist. Anschließend wird in Schritt h) die zweite Rahmenschale 102 auf der ersten Rahmenschale 101 und dem laminierten Schichtstapel 7 angeordnet. Alternativ kann der laminierte Schichtstapel 7 jedoch auch an einer Auflagefläche der zweite Rahmenschale 102 angeordnet werden und die erste Rahmenschale 101 auf dem laminierten Schichtstapel 7 und der zweiten Rahmenschale 102 angeordnet werden. Die Auflageflächen der Rahmenschalen 101, 102 werden mit Bezug auf die Fig. 2a und 2b näher erläutert.

Die mindestens eine Auflagefläche zum Einlegen des laminierten Schichtstapels 7 in die erste Rahmenschale 101 bzw. zweite Rahmenschale 102 kann bevorzugt in einer Vertiefung der ersten Rahmenschale 101 bzw. zweiten Rahmenschale 102 ausgebildet sein. Die Vertiefung kann zumindest abschnittsweise kongruent zum laminierten Schichtstapel7 geformt sein. Insbesondere kann eine Innenkontur der Vertiefung der ersten Rahmenschale 101 bzw. der zweiten Rahmenschalen 102 kongruent zu einer Außenkontur des laminierten Schichtstapels 7 in der Ebene des Schichtstapels geformt sein. In der Figur 1 sind die Rahmenschalen 101, 102 beispielsweise als Rechteckrahmenschalen ausgebildet, um ein rechteckförmigen laminierten Schichtstapel 7 zu rahmen. Das Verfahren kann jedoch auch an nicht-rechteckförmige laminierten Schichtstapeln durchgeführt werden.

Bevorzugt sind die erste Rahmenschale 101 und die zweite Rahmenschale 102, um das Verfahren zu vereinfachen, wie in Figur 1 dargestellt, als in sich geschlossene Rahmenschalen ausgebildet. Dadurch entfällt der Zusammenbau einzelner Bauteile zu einer Rahmenschale und die Herstellung von gerahmten Solarmodulen bzw. -arrays kann beschleunigt werden. Für eine verbesserte Stabilität können die Rahmenschalen 101, 102, wie im Beispiel der Figur 1, außerdem monolithisch ausgebildet sein, d. h. aus einem Stück bestehen. Sie können insbesondere in einem Stück gefertigt, bevorzugt gegossen, sein.

Die erste Rahmenschale 101 weist typischerweise in der Vertiefung eine durchgehenden Öffnung 110 auf, durch die Sonnenlicht für den Betrieb des Solarmoduls bzw. -arrays auf die Solarzellen 4 bzw. -module4 fallen kann. Die Öffnungsmaße der Öffnung 110 können wenigstens den Abmaßen der Anordnung der mindestens zwei Strings 3 in der Ebene des laminierten Schichtstapels 7 entsprechen. Die zweite Rahmenschale 102 kann, wie in der Fig. 1 und den Fig. 2a und 2b dargestellt, ebenfalls mit einer durchgehenden Öffnung 111 ausgebildet sein. Sie kann in Ausführungsformen jedoch auch rückseitig geschlossen sein, d.h. keine durchgehende Öffnung, aber gegebenenfalls eine Vertiefung aufweisen.

Für das Rahmen der Solarmodule bzw. -arrays werden die erste Rahmenschale 101 und die zweite Rahmenschale 102 zu einem Rahmen 100 zusammengefügt. An der ersten Rahmenschale 101 und der zweiten Rahmenschale 102 können hierfür Fügeflächenvorgesehen sein, die beim Fügen in einem berührenden Kontakt zueinander angeordnet werden. Vorteilhaft sind die Fügeflächen umlaufend, bevorzugt parallel zu mindestens einer Auflagefläche für den laminierten Schichtstapel7, um die Vertiefung in der ersten Rahmenschale 101 und die Vertiefung und bzw. oder eine durchgehende Öffnung 111 in der zweiten Rahmenschale 102 ausgebildet.

Das Zusammenfügen der ersten Rahmenschale 101 und der zweiten Rahmenschale 102 zum Rahmen 100 erfolgt bevorzugt form- und bzw. oder kraftschlüssig, z. B. durch Druckfügen, Verpressen, Umformen, Verschrauben oder Verklemmen. Es ist alternativ oder zusätzlich aber auch ein stoffschlüssiges Fügen, z. B. durch Verschweißen, Verlöten oder Verkleben der Rahmenschalen 101, 102 möglich. Für das Verklemmen können insbesondere lösbare Verbindungelemente, wie Clipverschlüsse bzw. Rastnasen und Einrastnuten, an der ersten und bzw. oder zweiten Rahmenschale 101, 102 vorgesehen sein.

Zur Abdichtung der Rahmenschalen 101, 102 können an den Auflageflächen zwischen dem laminierten Schichtstapel 7 und der ersten oder zweiten Rahmenschale 101, 102 und bzw. oder an Fügeflächen zwischen den Rahmenschalen 101, 102 Dichtelemente vorgesehen sein. Im Ausführungsbeispiel der Figur 1 sind diese Dichtelemente beispielhaft in den Schritten f) und g) mit gestrichelten Linien angedeutet.

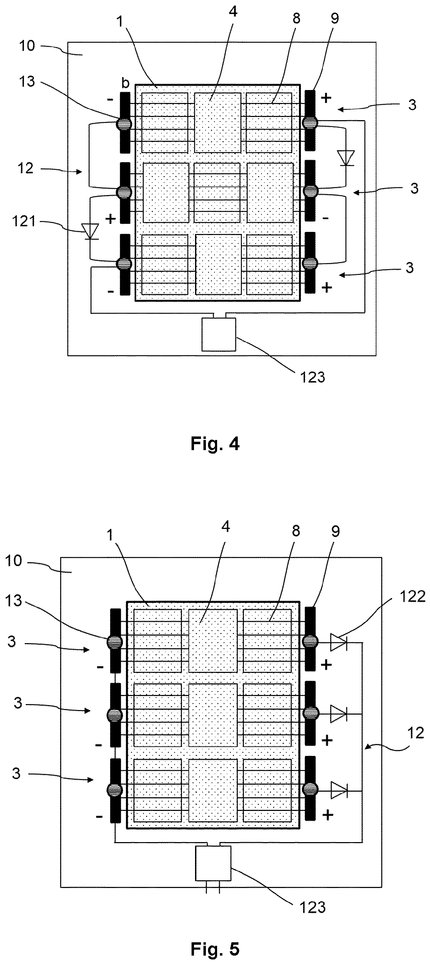

Beim Zusammenfügen der Rahmenschalen 101, 102 zum Rahmen 100 erfolgt bei dem erfindungsgemäßen Verfahren gleichzeitig auch die elektrische Kontaktierung der mindestens zwei Strings 3 bzw. Solarzellen 4 oder Solarmodule 4, sodass weitere Arbeitsschritte für eine elektrische Kontaktierung entfallen. Dafür sind die erste Rahmenschale 101 und bzw. oder die zweite Rahmenschale 102 als Schaltungsträger 11 ausgebildet. Dies bedeutet, dass die erste Rahmenschale 101 und bzw. oder die zweite Rahmenschale 102 eine elektrische Schaltung 12 und Kontaktierungskontakte 13 aufweist bzw. aufweisen. In den in den Fig. 1 und 2a und 2b dargestellten Beispielen ist jeweils die zweite Rahmenschale 102 als Schaltungsträger 11 ausgebildet. Die Kontaktierungskontakte 13 sind derart ausgebildet, dass sie beim Erzeugen des Rahmens 100, hier also beim Zusammenfügen der ersten Rahmenschale 101 und der zweite Rahmenschale 102, den laminierten Schichtstapel 7, zumindest bis zu den Kontaktflächen 9, durchdringen und die Kontaktflächen 9 elektrisch kontaktieren, sodass zwischen den mindestens zwei Strings 3 und der elektrischen Schaltung 12 ein elektrischer Kontakt gebildet wird. Die elektrische Schaltung 12 der ersten Rahmenschale 101 und bzw. oder der zweiten Rahmenschale 102 kann vorteilhaft ausgebildet sein, die mindestens zwei Strings 3 aus Solarzellen 4 oder Solarmodulen 4 elektrisch in Reihe oder parallel zueinander zu verschalten. Mögliche Ausführungsbeispiele für elektrische Schaltungen sind schematisch in den Figuren4 bis 7 dargestellt.

Für die elektrische Kontaktierung können die Kontaktierungskontakte 13 bevorzugt an Auflageflächen der ersten Rahmenschale 101 und bzw. oder zweiten Rahmenschale 102 angeordnet sein, an denen der laminierte Schichtstapel7 nach dem Zusammenfügen der Rahmenschalen 101, 102 mit der Vorderseitenschicht 1, der ersten Verkapselungsschicht 2, der zweiten Verkapselungsschicht 5 oder der Rückseitenschicht 6 in berührendem Kontakt angeordnet ist. Die Kontaktflächen 9 können dementsprechend in Randbereichen des laminierten Schichtstapels 7 angeordnet sein, die beim Zusammenfügen der ersten und zweiten Rahmenschale 101, 102 an diesen Auflageflächen der ersten oder zweiten Rahmenschale 101, 102 angeordnet sind bzw. anliegen, wobei die Randbereiche elektrisch isolierend ausgebildet sind. Die Kontaktflächen 9 können beispielsweise, wie in Schritt c) der Figur 1 dargestellt, in Randbereichen der ersten und zweiten Verkapselungsschicht 1, 5, parallel zu Außenkanten der ersten und zweiten Verkapselungsschicht 1, 5, angeordnet sein.

Damit die Kontaktierungskontakte 13 den Schichtstapel 7, insbesondere die Verkapselungsschichten 2, 5 und/oder die Rückseitenschicht 6, leichter durchdringen können, können die Kontaktierungskontakte 13 für das Zusammenfügen der Rahmenschalen 101, 102 und Kontaktieren der Kontaktflächen 9 auch erhitzt werden. Die Temperatur kann insbesondere höher als die Schmelztemperatur der Schichten sein, die für die Kontaktierung durchdrungen werden.

Das Verfahren kann beispielsweise mit dem Rahmenmodul 10 des Ausführungsbeispiels der Figuren 2a und 2b ausgeführt werden. D.h. die erste Rahmenschale 101 und die zweite Rahmenschale 102 können Merkmale des Rahmenmoduls 10 des Ausführungsbeispiels in den Figuren 2a und 2b aufweisen.

In den Figuren 2a und 2b ist schematisch ein Ausführungsbeispiel eines erfindungsgemäßen Rahmenmoduls 10, welches zwei Rahmenschalen 101, 102 enthält, dargestellt. Dabei zeigen Fig. 2a das Rahmenmodul 10 bei der Bereitstellung und Fig. 2b ein gerahmtes Solarmodul nach dem Zusammenfügen der ersten Rahmenschale 101 und der zweiten Rahmenschale 102 zum Rahmen 100 in einer seitlichen Schnittansicht, wobei in Fig. 2b nur ein Teil des gerahmten Solarmoduls dargestellt ist.

Das Rahmenmodul 10 umfasst die erste Rahmenschale 101 und die zweite Rahmenschale 102, die zum Rahmen 100 zusammenfügbar sind und derart ausgebildet sind, dass zwischen der ersten Rahmenschale 101 und der zweiten Rahmenschale 102 der laminierte Schichtstapel 7 anordenbar ist. Im dargestellten Beispiel ist die zweite Rahmenschale 102 als Schaltungsträger 11 ausgebildet, das heißt sie umfasst eine elektrische Schaltung 12 und Kontaktierungskontakte 13. Die Kontaktierungskontakte 13 sind derart ausgebildet, dass sie beim Zusammenfügen der ersten Rahmenschale 101 und der zweiten Rahmenschale 102 zum Rahmen 100 den laminierten Schichtstapel 7, zumindest bis zu den Kontaktflächen 9 des laminierten Schichtstapels 7, durchdringen und die Kontaktflächen 9 der mindestens zwei Strings 3 elektrisch kontaktieren und einen elektrischen Kontakt zwischen den mindestens zwei Strings 3 und der elektrischen Schaltung 12 bilden.

Für eine einfache Positionierung des laminierten Schichtstapels7 ist die erste Rahmenschale 101 mit einer Vertiefung ausgebildet, die im Wesentlichen kongruent zum laminierten Schichtstapel 7 geformt ist. Die Vertiefung weist eine erste Auflagefläche 103 für die Vorderseitenschicht 1 und eine zweite Auflagefläche 104 für die erste Verkapselungsschicht 2 auf. Die erste Auflagefläche 103 und die zweite Auflagefläche 104 sind um die Schichtdicke der Vorderseitenschicht 1 vertikal in Bezug auf die Eben des laminierten Schichtstapels 7 zueinander versetzt.

Weiter ist an der zweite Rahmenschale 102 eine dritte Auflagefläche 105 ausgebildet, an der nach dem Zusammenfügen der Rahmenschalen 101, 102 eine Außenkante, und somit ein Randbereich der Rückseitenschicht 6, angeordnet ist. Die dritte Auflagefläche 105 ist im Rahmenmodul 10 des Ausführungsbeispiels der Figuren 2a und 2b bündig mit einer Fügefläche 113 der zweiten Rahmenschale 102 gebildet. Die erste Rahmenschale 101 weist ebenfalls eine Fügefläche 112 auf, so dass die Rahmenschalen 101, 102 nach dem Zusammenfügen an den Fügeflächen 112, 113 in berührendem Kontakt zueinander angeordnet sind. Eine der Fügeflächen 112, 113 kann jedoch in weiteren Ausführungsformen auch ganz oder teilweise in einer Vertiefung in der entsprechenden Rahmenschale 101 bzw. 102 angeordnet sein. Die Rückseitenschicht 6 überragt die erste Verkapselungsschicht 2, die zweite Verkapselungsschicht 5, die Kontaktflächen 9 und die Vorderseitenschicht 1 an deren Außenkanten bzw. Randbereichen horizontal zur Ebene des laminierten Schichtstapels 7. Der Abstand der zweiten Auflagefläche 104 zur Fügefläche 112 entspricht im Ausführungsbeispiel der Figuren 2a und 2b der Summe der Schichtdicken der Rückseitenschicht 6 und der ersten und zweiten Verkapselungsschicht 2, 5 sodass die Rückseitenschicht 6 des laminierten Schichtstapel 7 mit seiner Oberfläche bündig mit der ersten Rahmenschale 101, bzw. deren Fügefläche 112 zur zweiten Rahmenschale 102, abschließt. In Ausführungsformen, in denen die dritte Auflagefläche 105 in einer Vertiefung in der zweiten Rahmenschale 102 angeordnet ist, kann es auch vorgesehen sein, dass der Abstand der zweiten Auflagefläche 104 zur Fügefläche 112 geringer als die Summe der Schichtdicken der Rückseitenschicht6 und der ersten und zweiten Verkapselungsschicht 2, 5 ist, sodass der laminierte Schichtstapel 7 beim Einlegen in die erste Rahmenschale 101über die erste Rahmenschale 101 übersteht und beim Zusammenfügen der Rahmenschalen 101, 102 von der Vertiefung der zweiten Rahmeschale 102 aufgenommen wird.

Die Auflageflächen 103, 104, 105 sind im Ausführungsbeispiel der Figuren 2a und 2b umlaufende Auflageflächen. Sie sind jeweils als zusammenhängende, planare Fläche an einem Innenumfang der Vertiefung der ersten Rahmenschale 101 und an der Öffnung 111 in der zweiten Rahmenschale 102 gebildet. Alternativ zu umlaufenden Auflageflächen können jedoch auch Auflageflächen mit Unterbrechungen der Flächen oder Vertiefungen in der Fläche der Auflagefläche vorgesehene sein. Die Auflageflächen können beispielsweise nur an zwei einander gegenüberliegenden Innenseiten der Vertiefung vorgesehen sein. In weiteren Ausführungsformen kann mindestens eine Auflagefläche mit einem Oberflächenprofil ausgebildet sein, das kongruent geformt zu einem Profil einer Außenkante des laminierten Schichtstapels 7 ausgebildet ist. Die Auflagefläche kann beispielsweise stufenartige, gewellte oder dreieckförmige Vertiefungen aufweisen, die beim Zusammenfügen der ersten und zweiten Rahmenschale 101, 102 in einen zinnenartig, wellenförmig oder gezackt geformten Randbereich des laminierten Schichtstapels 7 greifen, sodass die Positionierung des laminierten Schichtstapels 7 erleichtert wird. Die stufenartigen Vertiefungen in der Auflagenfläche können aber auch derart ausgebildet sein, dass vertikale Höhenunterschiede der Stufen einem vertikalen Versatz der Leiterstruktur 8 und bzw. oder der Kontaktflächen 9 in Bezug auf die Ebene des laminierten Schichtstapels 7 entsprechen.

Die Breite der ersten und zweiten Auflageflächen 103, 104 entspricht im Ausführungsbeispiel der Figuren 2a und 2b mindestens der Breite des Randbereiches der ersten und zweiten Verkapselungsschicht 2, 5, in dem keine Solarzellen 4 oder Solarmodule 4 angeordnet sind, sodass dieser Randbereich nach dem Zusammenfügen der ersten Rahmenschale 101 und der zweiten Rahmenschale 102 von der ersten und zweiten Auflagefläche 103, 104 nach außen, d.h. zur Vorderseite des Rahmens, auf die im Betrieb Sonnenlicht einfällt, verdeckt ist. Im Ausführungsbeispiel der Figuren 2a und 2b sind insbesondere auch die Kontaktflächen 9 nach außen durch die erste und zweite Auflagefläche 103, 104 verdeckt, sodass sie vor direkter Sonneneinstrahlung geschützt sind.

Die Vertiefung in der ersten Rahmenschale 101 ist im Ausführungsbeispiel der Figuren 2a und 2b ferner derart ausgebildet, dass nach dem Zusammenfügen der ersten und der zweiten Rahmenschale 101, 102 im Bereich der ersten Verkapselungsschicht2 und der zweiten Verkapselungsschicht 5 ein größeres Spaltmaß zwischen jeweiligen Seitenflächen 106 der Vertiefung und dem laminierten Schichtstapel 7 ausgebildet ist als in Bereichen der Rückseitenschicht 6 und der Vorderseitenschicht 1. Das Spaltmaß zwischen der Rückseitenschicht 6 und den Seitenflächen 106 der zweiten Auflagefläche 104, an der nach dem Zusammenfügen der Rahmenschalen 101, 102 die Rückseitenschicht 6 in der ersten Rahmenschale 101 anliegt, und das Spaltmaß zwischen der Vorderseitenschicht 1 und den Seitenflächen 106 der ersten Auflagefläche 103, an der nach dem Zusammenfügen der Rahmenschalen 101, 102 die Vorderseitenschicht 1 anliegt, ist kleiner als die Breite b der Kontaktflächen 9. Dadurch können die Kontaktflächen 9 auch bei seitlichen Verschiebungen des laminierten Schichtstapels 7 in der ersten Rahmenschale 101 noch ohne eine Korrektur der Position des laminierten Schichtstapels 7 kontaktiert werden.

Im Ausführungsbeispiel der Figuren 2a und 2b weist das Rahmenmodul 10 ein erstes Dichtelement 107 zur Abdichtung der ersten Rahmenschale 101 gegen die Vorderseitenschicht 1, ein zweites Dichtelement 108 zur Abdichtung der zweiten Rahmenschale 102 gegen die Rückseitenschicht 6 und ein drittes Dichtelement 109 zur Abdichtung der ersten Rahmenschale 101 gegen die zweite Rahmenschale 102 auf. Das erste Dichtelement 107 ist an der ersten Auflagefläche 103 der ersten Rahmenschale 101 angeordnet, an der die Vorderseitenschicht 1 nach Zusammenfügen der ersten und zweiten Rahmenschale 101, 102 mit der ersten Rahmenschale 101 in berührendem Kontakt ist. Das zweite Dichtelement 108 ist an der dritten Auflagefläche 105 an der zweiten Rahmenschale 102 angeordnet, an der die Rückseitenschicht 6 nach Zusammenfügen der ersten und zweiten Rahmenschale 101, 102 mit der zweiten Rahmenschale 102 in berührendem Kontakt ist. Das dritte Dichtelement 109 ist an einer Fügefläche 112 der ersten Rahmenschale 101 angeordnet, an der die Rahmenschalen 101, 102 nach dem Zusammenfügen in berührendem Kontakt zueinander sind. Für eine lösbare Verbindung der Rahmenschalen 101, 102 sind die Dichtelemente 107, 108, 109 im Ausführungsbeispiel der Figur 2b als Dichtschnüre ausgebildet, die in umlaufende Nuten in der Vertiefung und bzw. oder an der Öffnung 110, 111 in der jeweiligen Rahmenschale 101, 102 eingelegt sind. Alternativ kann jedoch auch eine Dichtmasse als Dichtelement verwendet werden. Diese kann insbesondere vor dem Zusammenfügen der Rahmenschalen 101, 102 auf die jeweilige Auflage- bzw. Fügefläche, insbesondere in umlaufende Nuten an diesen Flächen, aufgebracht, insbesondere aufgespritzt, werden.

Für die elektrische Kontaktierung der Strings 3 sind die Kontaktierungskontakte 13 im Ausführungsbeispiel der Figuren 2a und 2b an der dritten Auflagefläche 105 an der zweiten Rahmenschale 102 ausgebildet, sodass die Kontaktierungskontakte 13 beim Zusammenfügen der ersten und zweiten Rahmenschale 101, 102 mindestens die Rückseitenschicht 6 und die zweite Verkapselungsschicht 5 durchdringen. Alternativ oder zusätzlich können Kontaktierungskontakte auch an Auflageflächen der ersten Rahmenschale 101 angeordnet sein, auf denen der laminierte Schichtstapel 7 nach dem Zusammenfügen der ersten und zweiten Rahmenschale 101, 102 mit der Vorderseitenschicht 1 oder der ersten Verkapselungsschicht 2 in berührendem Kontakt angeordnet ist, sodass diese beim Zusammenfügen der ersten und zweiten Rahmenschale 101, 102 von den Kontaktierungskontakte durchdrungen werden.

Die Kontaktierungskontakte 13 sind im Wesentlichen senkrecht zu den Auflageflächen 103, 104 bzw. 105 angeordnet, sodass sie den laminierten Schichtstapel 7 für die elektrische Kontaktierung im Wesentlichen senkrecht durchdringen und die Kontaktfläche 9 im Wesentlichen senkrecht kontaktieren. Für eine einfache Kontaktierung sind die Kontaktierungskontakte 13 zueinander in demselben Abstand beabstandet wie die Kontaktflächen 9 in der Ebene des laminierten Schichtstapels 7.

Im Ausführungsbeispiel der Figuren 2a und 2b sind die Kontaktierungskontakte 13 vorteilhaft als Schneidkontakte ausgebildet, sie können jedoch auch als Klemmen ausgebildet sein. Die Kontaktierungskontakte 13 können als Schneidbleche oder als Kontaktierungsstifte ausgebildet sein. Die Schneidbleche können insbesondere mit einer keilförmigen Schneidkante, die Kontaktierungsstifte mit einer konisch zulaufenden Spitze ausgebildet sein.

Die jeweilige Länge der Kontaktierungskontakte 13, mit der die Kontaktierungskontakte 13 den laminierten Schichtstapel 7 durchdringen, kann wenigstens den Abstand zwischen einer Kontaktfläche 9, die mit dem jeweiligen Kontaktierungskontakte 13 beim Zusammenfügen der Rahmenschalen 101, 102 kontaktiert wird, und der jeweiligen Oberfläche des laminierten Schichtstapels 7, an der der laminierte Schichtstapel 7 von dem jeweiligen Kontaktierungskontakt 13 beim Zusammenfügen der Rahmenschale 101, 102 durchdrungen wird, betragen. Wird der laminierte Schichtstapel, wie im Beispiel der Figur 2b an der Rückseitenschicht 6 durchdrungen, so kann die Länge eines Kontaktierungskontaktes 13 wenigstens dem Abstand zwischen der Außenfläche der Rückseitenschicht 6 und der jeweiligen Kontaktfläche 9 betragen.

Im Ausführungsbeispiel der Figur 2b entspricht die Länge sämtlicher Kontaktierungskontakte 13, mit der die Kontaktierungskontakte 13 den laminierten Schichtstapel 7 durchdringen, wenigstem dem maximalen Abstand zwischen den Kontaktflächen 9 und der Oberfläche des laminierten Schichtstapels 7, an der der laminierte Schichtstapel 7 von den Kontaktierungskontakten 13 zum elektrischen Kontaktieren der Kontaktflächen 9 beim Zusammenfügen der Rahmenschalen 101, 102 durchdrungen wird. Dadurch dass sämtliche Kontaktierungskontakte 13 mindestens den maximalen Abstand zwischen den Kontaktflächen 9 und der Oberfläche des laminierten Schichtstapels 7 durchdringen können, können sämtliche Kontaktflächen 9, auch wenn sie im laminierten Schichtstapel 7 vertikal zueinander versetzt sind, elektrisch kontaktiert werden und Abweichungen in der vertikalen Position der Kontaktflächen 9 zueinander einfach ausgeglichen werden. Die Kontaktierungskontakt 13 können dabei je nach Abstand nicht nur in einen berührenden Kontakt mit der Kontaktfläche 9 gebracht werden, sondern diese auch durchdringen, wodurch eine zusätzliche Lagefixierung des laminierten Schichtstapels 7 bewirkt wird.

Im Ausführungsbeispiel der Figur 2 sind die Kontaktierungskontakte 13 insbesondere ausgebildet, jeweils mehrere in Bezug auf die Ebene des laminierten Schichtstapels7 vertikal übereinander angeordnete Kontaktflächen 9 (nicht dargestellt) zu kontaktieren. Die übereinander angeordneten Kontaktflächen 9 können beispielsweise Kontaktflächen 9 von verschiedenen, insbesondere nebeneinander angeordneten, Strings 3, Solarzellen 4 oder Solarmodulen 4 sein. Dadurch können mit dem Rahmenmodul dreidimensionale Verschaltungen zwischen Solarzellen 4 oder Solarmodulen 4 bzw. Strings 3 aus Solarzellen 4 oder Solarmodulen 4 ausgebildet werden.

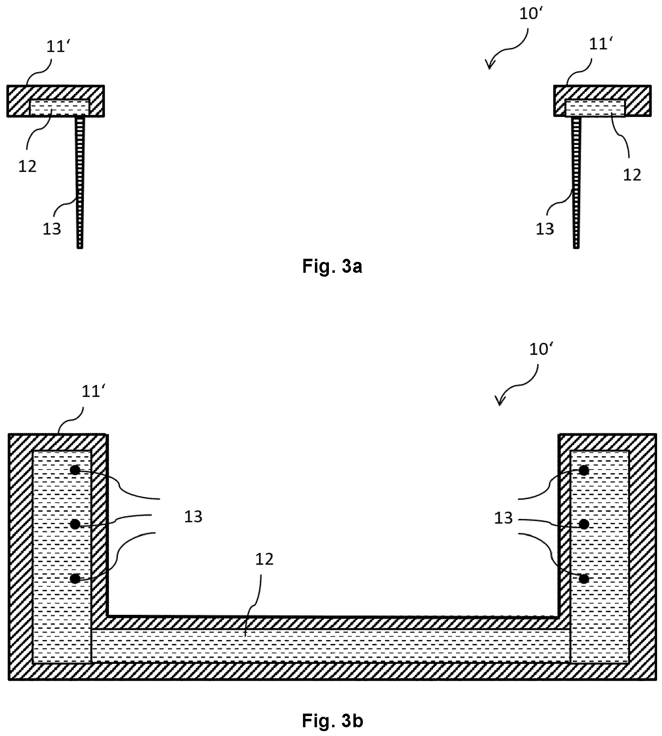

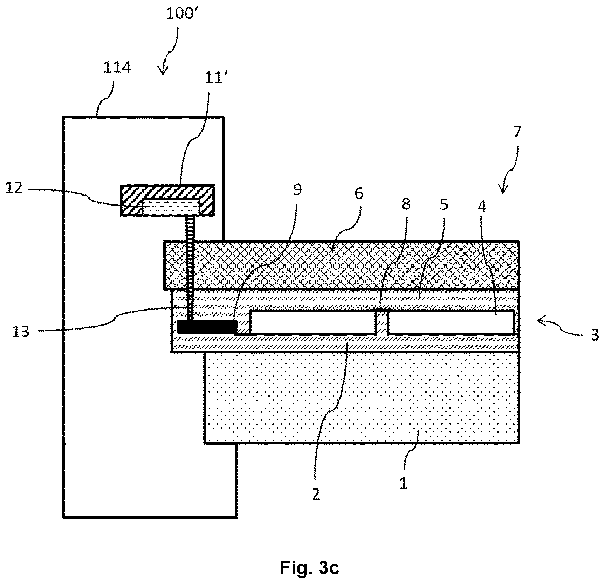

Für eine einfache Fertigung von gerahmten Solarmodulen oder -arrays sind die erste Rahmenschale 101 und bzw. oder die zweite Rahmenschale 102 des Ausführungsbeispiels der Figuren 2a und 2b bevorzugt als schaltungsintegrierte Schaltungsträger 11 ausgebildet. Dafür ist die elektrische Schaltung 12 in eine Oberfläche und bzw. oder an einer Oberfläche der ersten und bzw. oder zweiten Rahmenschale 101, 102 angeordnet, wobei die Oberfläche elektrisch isolierend ist. Die elektrische Schaltung 12 kann beispielsweise in die erste Rahmenschale 101 und bzw. oder zweite Rahmenschale 102 z.B. eingelassen oder eingegossen sein und bzw. oder auf diese abgeschieden oder aufgedruckt sein, sodass die jeweilige Rahmenschale 101, 102 eine Leiterplatte für die elektrische Schaltung 12 darstellt. Die Kontaktierungskontakte 13 können an oder in einer elektrisch isolierenden Oberfläche der ersten und bzw. oder zweite Rahmenschale 101, 102 befestigt sein, z.B. eingegossen, verklebt oder verschraubt sein. Weitere Beispiele für schaltungsintegrierte Schaltungsträger 11 sind in den Figuren 3 bis 6 dargestellt.

Die erste Rahmenschale 101 und bzw. oder die zweite Rahmenschale 102 bestehen für eine verbesserte Durchschlagfestigkeit vorteilhaft aus einem elektrisch isolierendem Material. Im Ausführungsbeispiels der Figuren 2a und 2b bestehen die erste Rahmenschale 101 und bzw. oder die zweite Rahmenschale 102 aus elektrisch isolierendem Kunststoff, insbesondere aus einem Thermoplast. Die Rahmenschalen 101, 102 sind in einem Warmpressverfahren oder einem Kunststoffgussverfahren, bevorzugt in einem Mehrkomponentenspritzgussverfahren, insbesondere in einem PCK-Verfahren oder einem SKW-Verfahren, hergestellt. Alternativ können die erste Rahmenschale 101 und bzw. oder die zweite Rahmenschale 12 jedoch auch aus einem Verbundwerkstoff oder aus Metall, insbesondere aus Aluminium, bestehen. Rahmenschalen 101, 102 aus Metall können insbesondere in einem Tiefziehverfahren oder Metallgussverfahren hergestellt sein. Die elektrische Schaltung 12 und bzw. oder Kontaktierungskontakte 13 kann bzw. können in die erste und bzw. oder zweite Rahmenschale 101, 102 eingelassen, beispielsweise in Vertiefungen eingeklebt, eingegossen, eingepresst oder eingeschraubt sein. Dabei kann bzw. können die elektrische Schaltung 12 und bzw. oder die Kontaktierungskontakte 13 bei Rahmenschalen 101, 102 aus Metall zur elektrischen Isolierung auf einer elektrisch isolierenden Leiterplatte angeordnet sein oder mit einem elektrisch isolierenden Kleber oder einer elektrisch isolierenden Vergussmasse an oder in einer Oberfläche der Rahmenschale befestigt sein. Bei Rahmenschalen 101, 102 aus einem Verbundwerkstoff kann es vorgesehen sein, dass Oberflächen des Verbundwerkstoffs, an und bzw. oder in denen die elektrische Schaltung 12 und bzw. oder die Kontaktierungskontakte 13 befestigt sind, aus einem elektrisch isolierenden Material, z.B. aus Kunststoff, ausgebildet sind.

Die elektrische Schaltung 12 der ersten Rahmenschale 101 und bzw. oder der zweiten Rahmenschale 102 ist ausgebildet, die mindestens zwei Strings 3 elektrisch in Reihe oder parallel zueinander zu verschalten. Die elektrische Schaltung umfasst neben einer elektrischen Verbindung für die Verschaltung der Strings 3, wie z.B. Drähten oder Stromsammelschienen, auch Bypass-Dioden und bzw. oder Sperrdioden zur Vermeidung von Überhitzungen durch Verschattung auf. Die Bypass-Dioden sind dabei parallel zu Strings 3 und bzw. oder jeweils parallel zu einzelnen Solarzellen 4 oder Solarmodulen 4 geschaltet. Die Sperrdioden sind jeweils in Reihe zu den String 3 geschaltet sein.

Darüber hinaus kann in die Rahmenschalen 101, 102 als Teil der elektrischen Schaltung 12 mindestens ein weiteres Bauelement integriert sein, ausgewählt aus den folgenden: ein Wechselrichter zur Umwandlung eines Gleichstroms der mindestens zwei Strings 3 in Wechselstrom, eine Sensorik für die Regelung des Betriebs des Solarmoduls oder des Solararrays, mindestens einen Akkumulator zur Energiespeicherung und ein Maximum Power Point Tracker (MPP-Tracker). Der MPP-Tracker kann in den mindestens einen Wechselrichter oder in einen Laderegler für den Akkumulator der elektrischen Schaltung oder einen externen Akkumulator integriert sein.

Für eine Integration von Bauelementen der elektrischen Schaltung 12, insbesondere des Wechselrichters, der Sensorik, des Akkumulators oder des Ladereglers, für eine Integration weiterer Komponenten zum Betrieb des Solarmoduls oder -arrays, für eine Kabelführung oder auch zur Gewichtsreduzierung können in der ersten Rahmenschale 101 und bzw. oder der zweiten Rahmenschale 102 außerdem weitere Vertiefungen oder Hohlräume (nicht dargestellt) vorgesehen sein. Die erste Rahmenschale 101 und bzw. oder die zweite Rahmenschale 102 können insbesondere als Hohlprofile ausgebildet sein. Die weiteren Vertiefungen können vorteilhaft an einer der Fügeflächen 112, 113 der ersten und zweiten Rahmenschale 101, 102 ausgebildet sein, sodass sie beim Öffnen des Rahmenmoduls zugängig sind.

Mit Bezug auf die Figuren 3a bis 3c wird ein anderes Ausführungsbeispiel des Rahmenmoduls erläutert, bei dem ein Rahmenmodul 10' keine Rahmenschalen oder andere Rahmenvorformlinge, sondern einen Schaltungsträger 11' enthält, aus dem allein heraus kein Rahmen des gerahmten Solarmoduls erzeugt werden kann. Mit anderen Worten: Ein solches Rahmenmodul 10' muss noch mit einem Material umhüllt werden, um einen Rahmen zu erzeugen, wobei während des Vorgangs des Umhüllens gleichzeitig der laminierte Schichtstapel 7 umhüllt bzw. eingefasst wird. Solch ein Umhüllvorgang kann bspw. durch Hinterspritzen des Schaltungsträgers 11' und des Randbereiches des Schichtstapels 7 mit einem Kunststoff erzeugt werden. Der Schaltungsträger 11' kann bspw. eine Folie aus Kunststoff sein, auf die eine Schaltung 12 und Kontaktierungskontakte 13 aufgebracht sind. Fig. 3a zeigt schematisch einen Querschnitt durch ein solches Rahmenmodul 11', während Fig. 3b schematisch eine Draufsicht auf das Rahmenmodul 11' zeigt. Fig. 3C zeigt schematisch einen Teil eines Querschnittes eines mit Hilfe des Rahmenmoduls 11' erzeugten gerahmten Solarmoduls.

Wie in Fig. 3b zu sehen ist, kann der Schaltungsträger 11' so ausgebildet sein, dass er die Kontaktierungskontakte 13, die die Kontaktflächen an beiden Enden der Strings des laminierten Schichtstapels kontaktieren, enthält und mittels der Schaltung 12 miteinander verschaltet. Selbstverständlich kann der Schaltungsträger 11' aber auch aus mehreren Teilträgern bestehen, die jeweils nur Kontaktierungskontakte 13 für die Kontaktflächen an einem Ende des Strings enthalten und die die anderweitig miteinander verschaltet werden, bspw. außerhalb des zu erzeugenden Rahmens.

Fig. 3c zeigt einen Teil eines gerahmten Solarmoduls, bei dem der Rahmen 100' eine Spritzgussmasse 114 enthält, die den Rand des laminierten Schichtstapels 7 und den Schaltungsträger 11' umhüllt. Da die Spritzgussmasse 114 dicht an die Oberflächen des laminierten Schichtstapels 7 anliegt, kann in diesem Fall auf zusätzliche Dichtelemente verzichtet werden. In anderen Ausführungsformen können aber zusätzliche Dichtelemente während des Erzeugens des Rahmens ebenfalls vorgesehen und mit in den Rahmen eingefügt werden. Während des Umhüllens des laminierten Schichtstapels 7 und des entsprechend zu diesem angeordneten Schaltungsträgers 11', bspw. in einer Spritzgussmaschine, wird der Schaltungsträger 11' so gegen den Schichtstapel 7 gedrückt, dass die Kontaktierungskontakte 13 den Schichtstapel 7, hier die Rückseitenschicht 6 und die zweite Verkapselungsschicht 5 durchdringen und die Kontaktflächen 9 elektrisch kontaktieren. Im dargestellten Fall durchdringen die Kontaktierungskontakte 13 die Kontaktflächen 9 nicht. Selbstverständlich können die Kontaktierungskontakte 13 auch die Kontaktflächen 9 durchdringen, ähnlich wie dies in Fig. 2b dargestellt ist.

Die Aussagen hinsichtlich der Anordnung, Breite und Länge der Kontaktierungskontakte 13 innerhalb des Schaltungsträgers 11 sowie zu Bestandteilen der elektrischen Schaltung 12, die mit Bezug auf die Figuren 2a und 2b gemacht wurden, können auch für den Schaltungsträger 11' gelten.

In den Figuren 4 bis 7 sind jeweils in einer schematischen, nicht-maßstäblichen Draufsicht Ausführungsbeispiele von elektrischen Schaltungen 12 erfindungsgemäßer Rahmenmodule, wie beispielsweise dem Rahmenmodul 10 der Figuren 2a und 2b, abgebildet. Zur besseren Veranschaulichung sind auch innenliegende elektrische Verbindungen und Bauelemente der elektrischen Schaltungen 12, die in einer Draufsicht von bspw. der ersten Rahmenschale 101 verdeckt wären, dargestellt. Die elektrischen Verbindungen zwischen den Kontaktierungskontakten 13 und bzw. oder Bauelementen der elektrischen Schaltung 12 können z.B. Drähte, Kabel oder Stromsammelschienen sein. Die elektrischen Verbindungen und Bauelemente der elektrischen Schaltung 12 können beispielsweise in oder an mindestens einer Seitenfläche, Auflagefläche und bzw. oder Fügefläche der ersten und bzw. oder zweiten Rahmenschale 101, 102 angeordnet sein. Bauelemente der elektrischen Schaltung 12 können bspw. Bypass-Dioden 121, Sperrdioden 122 oder weitere Bauelemente 123 für den Betrieb des Solarmoduls bzw. -arrays sein. Solche weiteren Bauelemente 123 können z.B. mindestens ein Wechselrichter zur Umwandlung eines Gleichstroms der mindestens zwei Strings 3 in Wechselstrom, eine Sensorik für die Regelung des Betriebs des Solarmoduls oder -arrays, mindestens ein Akkumulator zur Energiespeicherung und bzw. oder ein Maximum Power Point Tracker (MPP-Tracker) sein. Der MPP-Tracker kann in den mindestens einen Wechselrichter oder in einen Laderegler für den Akkumulator der elektrischen Schaltung oder für einen externen Akkumulator integriert sein.

Figur 4 zeigt schematisch ein Ausführungsbeispiel einer Reihenschaltung von Strings 3 in einer vorderseitigen Draufsicht auf ein gerahmtes Solarmodul bzw. -array. Für eine Reihenschaltung der Strings 3 sind diese jeweils gegenpolig zueinander angeordnet, sodass jeweils gegenpolige Kontaktflächen 9 der Strings 3 nebeneinander in einem Randbereich parallel zu einer Außenkante des laminierten Schichtstapels 7 angeordnet sind und mit den Kontaktierungskontakten 13 und einer elektrischen Verbindung zwischen den Kontaktierungskontakten 13 in dem Rahmenmodul 10 miteinander verschaltet sind. In den Strings 3 sind die Solarzellen 4 bzw. -module 4 bei diesem Beispiel jeweils elektrisch in Reihe miteinander verbunden. Außerdem sind im Beispiel der Figur 4 Bypass-Dioden 121 parallel zu den Strings 3 geschaltet. Alternativ oder zusätzlich können auch Bypass-Dioden parallel zu einzelnen Solarzellen 4 oder Solarmodulen 4 geschaltet sein.

In Figur 5 ist schematisch ein Ausführungsbeispiel einer Parallelschaltung von Strings 3 in einer vorderseitigen Draufsicht auf ein gerahmtes Solarmodul bzw. -array dargestellt. Für die Parallelschaltung der Strings 3 sind diese jeweils gleichnamig gepolt zueinander angeordnet, sodass jeweils gleichnamig gepolten Kontaktflächen 9 der Strings 3 nebeneinander in einem Randbereich parallel zu einer Außenkante des laminierten Schichtstapels 7 angeordnet sind und mit den Kontaktierungskontakten 13 und einer elektrischen Verbindung zwischen den Kontaktierungskontakten 13 in dem Rahmenmodul 10 miteinander verschaltet sind. In den Strings 3 sind die Solarzellen 4 bzw. -module 4 bei diesem Beispiel jeweils elektrisch in Reihe miteinander verbunden. Außerdem sind im Beispiel der Figur5 Sperrdioden 122 jeweils in Reihe zu den Strings 3 geschaltet, alternativ oder zusätzlich können auch Sperrdioden parallel zu einzelnen Solarzellen 4 oder Solarmodulen 4 geschaltet sein.

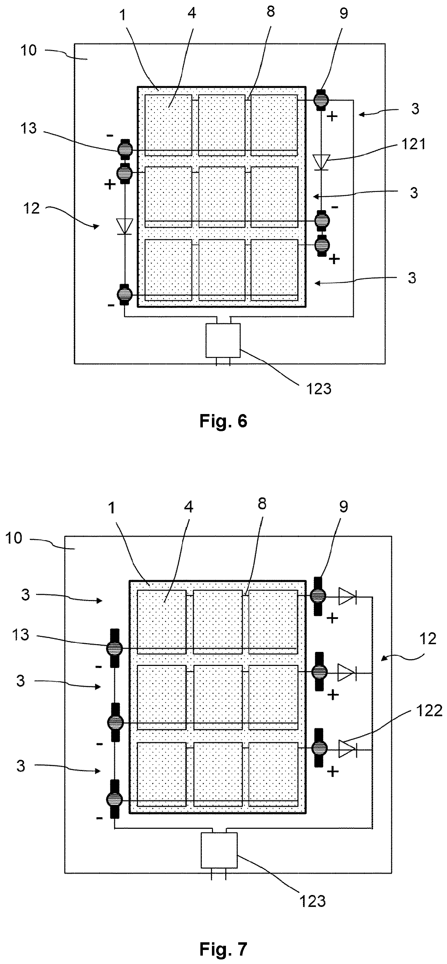

Figur 6 zeigt schematisch ein Ausführungsbeispiel einer Reihenschaltung von Strings 3 in einer vorderseitigen Draufsicht auf ein gerahmtes Solarmodul bzw. -array. Im Gegensatz zum Beispiel der Figur 4 sind die Solarzellen 4 bzw. -module 4 in den Strings 3 elektrisch parallel zueinander verbunden. Die Strings 3 sind gleichnamig gepolt angeordnet, wobei jeweils gegenpolige Kontaktflächen 9 der Strings 3 nebeneinander in einem Randbereich parallel zu einer Außenkante des laminierten Schichtstapels 7 angeordnet sind und mit den Kontaktierungskontakten 13 und einer elektrischen Verbindung zwischen den Kontaktierungskontakten 13 in dem Rahmenmodul 10 miteinander verschaltet sind. Außerdem sind im Beispiel der Figur 6 Bypass-Dioden 121 parallel zu den Strings 3 geschaltet. Alternativ oder zusätzlich können auch Sperrdioden jeweils in Reihe zu einzelnen Solarzellen 4 oder Solarmodulen 4 geschaltet sein.

In Figur 7 ist schematisch ein Ausführungsbeispiel einer Parallelschaltung von Strings 3 in einer vorderseitigen Draufsicht auf ein gerahmtes Solarmodul bzw. -array dargestellt. Im Gegensatz zum Beispiel der Figur 5 sind die Solarzellen 4 bzw. -module 4 in den Strings 3 elektrisch parallel zueinander verbunden. Die Strings 3 sind gleichnamig gepolt angeordnet, wobei jeweils gleichnamig gepolt Kontaktflächen 9 der Strings 3 nebeneinander in einem Randbereich parallel zu einer Außenkante des laminierten Schichtstapels 7 angeordnet sind und mit den Kontaktierungskontakten 13 und einer elektrischen Verbindung zwischen den Kontaktierungskontakten 13 in dem Rahmenmodul 10 miteinander verschaltet sind. Außerdem sind im Beispiel der Figur 7 Sperrdioden 122 jeweils in Reihe zu den Strings 3 geschaltet. Alternativ oder zusätzlich können auch Sperrdioden jeweils in Reihe zu einzelnen Solarzellen 4 oder Solarmodulen 4 geschaltet sein.

### Bezugszeichenliste

| | |
|---|---|
| 1 | Vorderseitenschicht |
| 2 | erste Verkapselungsschicht |
| 3 | String aus Solarzellen oder Solarmodulen |
| 4 | Solarzelle oder Solarmodul |
| 5 | zweite Verkapselungsschicht |
| 6 | Rückseitenschicht |
| 7 | laminierter Schichtstapel |
| 8 | elektrisch leitfähige Leiterstruktur |
| 9 | elektrisch leitfähige Kontaktflächen |
| 10, 10` | Rahmenmodul |
| 100, 100' | Rahmen |
| 101 | erste Rahmenschale |
| 102 | zweite Rahmenschale |
| 103 | erste Auflagefläche |
| 104 | zweite Auflagefläche |
| 105 | dritte Auflagefläche |
| 106 | Seitenfläche |
| 107 | erstes Dichtelement an erster Auflagefläche |
| 108 | zweites Dichtelement an dritter Auflagefläche |
| 109 | drittes Dichtelement an Fügefläche |
| 110 | Öffnung in der ersten Rahmenschale |
| 111 | Öffnung in der zweiten Rahmenschale |
| 112 | Fügefläche der ersten Rahmenschale |
| 113 | Fügefläche der zweiten Rahmenschale |
| 114 | Spritzgussmasse |
| 11, 11' | Schaltungsträger |
| 12 | elektrische Schaltung |
| 121 | Bypass-Diode |
| 122 | Sperrdiode |
| 123 | Weiteres Bauelement |
| 13 | elektrisch leitfähige Kontaktierungskontakte |
| b | Breite einer Kontaktfläche |

## Patentansprüche

1. Verfahren zur Herstellung eines gerahmten Solarmoduls aus Solarzellen oder eines gerahmten Solararrays aus Solarmodulen, mit den Schritten:
a) Bereitstellen eines Schichtstapels (7) aus einer Vorderseitenschicht (1), einer ersten Verkapselungsschicht (2), mindestens zwei Strings (3) aus Solarzellen (4) oder Solarmodulen (4), einer zweiten Verkapselungsschicht (5) und einer Rückseitenschicht (6), wobei
- die Solarzellen (4) oder Solarmodule (4') in den mindestens zwei Strings (3) jeweils mit einer elektrisch leitfähigen Leiterstruktur (8) elektrisch in Reihe oder elektrisch parallel zueinander verbunden sind,
- an den mindestens zwei Strings (3) jeweils endseitig eine elektrisch leitfähige Kontaktfläche (9) an der elektrisch leitfähigen Leiterstruktur (8) ausgebildet ist,
- der Schichtstapel derart laminiert ist, dass durch Laminieren der ersten Verkapselungsschicht (2) und der zweiten Verkapselungsschicht (5) die mindestens zwei Strings (3) von der ersten Verkapselungsschicht (2) und der zweiten Verkapselungsschicht (5) umgeben sind,
b) Bereitstellen eines Rahmenmoduls (10, 10'), das einen Schaltungsträger (11, 11') mit einer elektrischen Schaltung (12) und elektrisch leitfähigen Kontaktierungskontakten (13) enthält, und
c) Erzeugen eines gerahmten Solarmoduls oder gerahmten Solararrays aus dem Schichtstapel (7) und dem Rahmenmodul (10, 10`), wobei der Schichtstapel (7) und das Rahmenmodul (10, 10`) zusammengefügt werden und ein Rahmen (100, 100`) erzeugt wird, so dass das gerahmte Solarmodul oder das gerahmte Solararray den Rahmen (100, 100') enthält, in dem der Schaltungsträger (11, 11') integriert ist,
wobei beim Erzeugen des Rahmens (100, 100`) im Schritt c) die elektrisch leitfähigen Kontaktierungskontakte (13) den Schichtstapel (7), zumindest bis zu den elektrisch leitfähigen Kontaktflächen (9), durchdringen und jeweils mindestens eine elektrisch leitfähige Kontaktfläche (9) elektrisch kontaktieren, sodass ein elektrischer Kontakt zwischen den mindestens zwei Strings (3) und der elektrischen Schaltung (12) gebildet wird.

2. Verfahren nach Anspruch 1, **dadurch gekennzeichnet, dass** die elektrisch leitfähigen Kontaktierungskontakte (13) jeweils mindestens die Rückseitenschicht (6) und/oder die zweite Verkapselungsschicht (5) oder die Vorderseitenschicht (1) und/oder die erste Verkapselungsschicht (2) durchdringen.

3. Verfahren nach einem der vorhergehenden Ansprüche, **dadurch gekennzeichnet, dass** der Schaltungsträger (11') und der Schichtstapel (7) in eine Form eingelegt werden und der Rahmen (100') durch ein Urformverfahren erzeugt wird, wobei der Schaltungsträger (11') in den Rahmen (100') integriert wird.

4. Verfahren nach einem der Ansprüche 1 oder 2, **dadurch gekennzeichnet, dass**
- das Rahmenmodul (10) eine erste Rahmenschale (101) und eine zweite Rahmenschale (102) enthält, wobei der Schaltungsträger (11) in die erste Rahmenschale (101) und/oder in die zweite Rahmenschale (102) integriert ist
- der Schichtstapel (7) zwischen der ersten Rahmenschale (101) und der zweiten Rahmenschale (102) angeordnet wird und
- der Rahmen (100) durch Zusammenfügen der ersten Rahmenschale (101) und der zweiten Rahmenschale (102) erzeugt wird.

5. Verfahren nach Anspruch 4, **dadurch gekennzeichnet, dass** die erste Rahmenschale (101) und die zweite Rahmenschale (102) jeweils als in sich geschlossene Rahmenschalen, insbesondere monolithische Rahmenschalen, ausgebildet sind.

6. Verfahren nach einem der Ansprüche 4 oder 5 **dadurch gekennzeichnet, dass** der Schichtstapel (7) zum Zusammenfügen der ersten Rahmenschale (101) und der zweiten Rahmenschale (102) in eine Vertiefung in der ersten Rahmenschale (101) oder in der zweiten Rahmenschale (102) eingelegt wird.

7. Verfahren nach einem der Ansprüche 4 bis 6, **dadurch gekennzeichnet, dass** Außenkanten der Vorderseitenschicht (1) und der ersten Verkapselungsschicht (2) in Bezug auf die Ebene des laminierten Schichtstapels (7) zueinander versetzt ausgebildet sind, sodass die Außenkanten der jeweiligen Schichten beim Zusammenfügen der ersten Rahmenschalen (101) und der zweiten Rahmenschalen (102) jeweils an zueinander versetzt angeordneten Auflageflächen der ersten Rahmenschalen (101) angeordnet sind.

8. Verfahren nach einem der vorhergehenden Ansprüche, **dadurch gekennzeichnet, dass** die elektrisch leitfähigen Kontaktierungskontakte (13) als Klemmen oder als Schneidkontakte, insbesondere als Schneidbleche oder Kontaktierungsstifte, ausgebildet sind.

9. Rahmenmodul (10, 10`) zur Herstellung eines gerahmten Solarmoduls oder eines gerahmten Solararrays mit einem Rahmen (100, 100`) und einem laminierten Schichtstapel (7), aufweisend eine Vorderseitenschicht (1), eine erste Verkapselungsschicht (2), mindestens zwei Strings (3) aus Solarzellen (4) oder Solarmodulen (4), eine zweite Verkapselungsschicht (5) und eine Rückseitenschicht (6), wobei
- die Solarzellen (4) oder Solarmodule (4') in den mindestens zwei Strings (3) jeweils mit einer elektrisch leitfähigen Leiterstruktur (8) elektrisch in Reihe oder elektrisch parallel zueinander verbunden sind,
- an den mindestens zwei Strings (3) jeweils endseitig eine elektrisch leitfähige Kontaktfläche (9) an der elektrisch leitfähigen Leiterstruktur (8) ausgebildet ist,
**dadurch gekennzeichnet, dass** das Rahmenmodul (10, 10`) einen Schaltungsträger (11, 11') mit einer elektrischen Schaltung (12) und elektrisch leitfähigen Kontaktierungskontakten (13) enthält, sodass beim Erzeugen des Rahmens (100, 100`) die elektrisch leitfähigen Kontaktierungskontakte (13) den laminierten Schichtstapel (7), zumindest bis zu den elektrisch leitfähigen Kontaktflächen (9), durchdringen und jeweils mindestens eine elektrisch leitfähige Kontaktfläche (9) elektrisch kontaktieren und einen elektrischen Kontakt zwischen den mindestens zwei Strings (3) und der elektrischen Schaltung (12) bilden.

10. Rahmenmodul nach Anspruch 9, **dadurch gekennzeichnet, dass**
- das Rahmenmodul (10) eine erste Rahmenschale (101) und eine zweite Rahmenschale (102) aufweist, die zu dem Rahmen (100) zusammenfügbar und derart ausgebildet sind, dass zwischen der ersten Rahmenschale (101) und der zweiten Rahmenschale (102) der laminierte Schichtstapel (7) anordenbar ist, und
- der Schaltungsträger (11) in der ersten Rahmenschale (101) und/oder der zweiten Rahmenschale (102) integriert ausgebildet ist, sodass beim Zusammenfügen der ersten Rahmenschale (101) und der zweiten Rahmenschale (102) die elektrisch leitfähigen Kontaktierungskontakte (13) den laminierten Schichtstapel (7), zumindest bis zu den elektrisch leitfähigen Kontaktflächen (9), durchdringen und jeweils mindestens eine elektrisch leitfähige Kontaktflächen (9) elektrisch kontaktieren und einen elektrischen Kontakt zwischen den mindestens zwei Strings (3) und der elektrischen Schaltung (12) bilden.

11. Rahmenmodul nach Anspruch 10, **dadurch gekennzeichnet, dass** die erste Rahmenschale (101) und die zweite Rahmenschale (102) als in sich geschlossene Rahmenschalen, insbesondere monolithische Rahmenschalen, ausgebildet sind.

12. Rahmenmodul nach Anspruch 10 oder 11, **dadurch gekennzeichnet, dass** die erste Rahmenschale (101) eine Vertiefung aufweist, die im Wesentlichen kongruent zum laminierten Schichtstapel (7) geformt ist, wobei die Vertiefung mindestens eine Auflagefläche (103, 104) aufweist.

13. Rahmenmodul nach einem der Ansprüche 9 bis 12, **dadurch gekennzeichnet, dass** die elektrisch leitfähigen Kontaktierungskontakte (13) als Schneidklemmen oder als Schneidkontakte, insbesondere als Schneidbleche oder Kontaktierungsstifte, ausgebildet sind.

14. Rahmenmodul nach einem der Ansprüche 9 bis 13, **dadurch gekennzeichnet, dass** die erste Rahmenschale (101) und/oder die zweite Rahmenschale (102) aus einem elektrisch isolierenden Material, insbesondere Kunststoff, bestehen.

15. Verwendung eines Rahmenmoduls (10) nach einem der Ansprüche 9 bis 14 zur Herstellung eines gerahmten Solarmoduls oder eines gerahmten Solararrays.

16. Solararray oder Solarmodul aufweisend einen Rahmen (100, 100`) erzeugt aus einem Rahmenmodul (10, 10`) nach einem der Ansprüche 9 bis 14.
